# EUROPEAN PATENT SPECIFICATION

(11) **EP 4 559 293 B1**
(45) Date of publication and mention of the grant of the patent: **16.07.2025**
(21) Application number: 23735484.0
(22) Date of filing: 31.05.2023
(51) Int. Cl.: H10D 30/47, H10D 30/67, H10D 62/80, H10D 84/01, H10D 84/03, H10D 84/85

(54) **2-D MATERIAL GATE-ALL-AROUND COMPLEMENTARY FET INTEGRATION**
2-D MATERIAL GATE-ALL-AROUND KOMPLEMENTÄRE FET INTEGRATION
PORTE EN MATÉRIAU 2-D POUR INTÉGRATION COMPLÈTE DE FET COMPLÉMENTAIRES

(30) Priority: 10.08.2022 US 202217818933
(43) Date of publication of application: 28.05.2025
(73) Proprietor: QUALCOMM INCORPORATED, San Diego, California 92121-1714 (US)
(72) Inventor: LI, Xia, San Diego, California 92121-1714 (US); YANG, Bin, San Diego, California 92121-1714 (US)
(74) Representative: Wimmer, Hubert
(86) International application number: PCT/US2023/024037
(87) International publication number: WO 2024/035473

(56) References cited:
- US-A1- 2021 265 345
- US-A1- 2022 199 838

## Description

### FIELD OF DISCLOSURE

This disclosure relates generally to high performance devices, and more specifically, but not exclusively, to devices with 2D-material gate-all-around (GAA) complementary field effect transistor (CFET) integration.

### BACKGROUND

Integrated circuit technology has achieved great strides in advancing computing power through miniaturization components such as semiconductor transistors. The progression of semiconductors have progressed from bulk substrates and planar CMOS, FinFETs, nanowires or nanoribbons, FinFET 3D stacking to nanowire or nanoribbon 3D stacking. The semiconductor technologies have largely been based on silicon. However, fabrication of transistors based on silicon may be problematic when it comes to further reduction in scaling, e.g., to few nanometers.

Accordingly, there is a need for systems, apparatus, and methods that overcome the deficiencies of conventional devices including the methods, system and apparatus provided herein. Attention is drawn to document US 2021/265345 A1 which relates to CFET devices having a gate-all-around structure. Attention is also drawn to document US 2022/199838 A1 which relates to a transistor including a channel layer including a transition metal dichalcogenide (TMD) material, an encapsulation layer on a first portion of the channel layer, a gate electrode above the encapsulation layer, a gate dielectric layer between the gate electrode and the encapsulation layer. The transistor further includes a source contact on a second portion of the channel layer and a drain contact on a third portion of the channel layer, where the gate structure is between drain contact and the source contact.

### SUMMARY

The present invention is defined by the appended independent claims. Further embodiments of the invention are defined by the appended dependent claims. The following presents a simplified summary relating to one or more aspects and/or examples associated with the apparatus and methods disclosed herein. As such, the following summary should not be considered an extensive overview relating to all contemplated aspects and/or examples, nor should the following summary be regarded to identify key or critical elements relating to all contemplated aspects and/or examples or to delineate the scope associated with any particular aspect and/or example. Accordingly, the following summary has the sole purpose to present certain concepts relating to one or more aspects and/or examples relating to the apparatus and methods disclosed herein in a simplified form to precede the detailed description presented below.

An exemplary complementary field effect transistor (CFET) structure is disclosed. The CFET structure may comprise a lower source contact and a lower drain contact in an intermetal dielectric (IMD) layer. The CFET structure may also comprise a lower gate-all-around (GAA) gate region in the IMD layer between the lower source and drain contacts. The lower GAA gate region may be a first conductivity type and may comprise one or more lower channel structures. Each lower channel structure may comprise a lower transition metal dichalcogenide (TMD) channel electrically coupled with the lower source contact and with the lower drain contact. Each lower channel structure may also comprise first and second lower gate oxide layers respectively on lower and upper surfaces of the lower TMD channel. The CFET structure may further comprise an upper source contact and an upper drain contact in the IMD layer above the lower source and drain contacts. The CFET structure may yet comprise an upper GAA gate region in the IMD layer above the lower GAA gate region and between the upper source and drain contacts. The upper GAA gate region may be a second conductivity type opposite the first conductivity type and may comprise one or more upper channel structures. Each upper channel structure may comprise an upper TMD channel electrically coupled with the upper source contact and with the upper drain contact. Each upper channel structure may also comprise first and second upper gate oxide layers respectively on upper and lower surfaces of the upper TMD channel. The CFET structure may yet further comprise a common gate in the IMD layer between the lower source and drain contacts and between the upper source and drain contacts. The common gate may be configured to apply a common voltage to the lower and upper channel structures.

A method of fabricating a complementary field effect transistor (CFET) structure is disclosed. The method may comprise forming a lower source contact and a lower drain contact in an intermetal dielectric (IMD) layer. The method may also comprise forming a lower gate-all-around (GAA) gate region in the IMD layer between the lower source and drain contacts. The lower GAA gate region may be a first conductivity type and may comprise one or more lower channel structures. Each lower channel structure may comprise a lower transition metal dichalcogenide (TMD) channel electrically coupled with the lower source contact and with the lower drain contact. Each lower channel structure may also comprise first and second lower gate oxide layers respectively on lower and upper surfaces of the lower TMD channel. The method may further comprise forming an upper source contact and an upper drain contact in the IMD layer above the lower source and drain contacts. The method may yet comprise forming an upper GAA gate region in the IMD layer above the lower GAA gate region and between the upper source and drain contacts. The upper GAA gate region may be a second conductivity type opposite the first conductivity type and may comprise one or more upper channel structures. Each upper channel structure may comprise an upper TMD channel electrically coupled with the upper source contact and with the upper drain contact. Each upper channel structure may also comprise first and second upper gate oxide layers respectively on upper and lower surfaces of the upper TMD channel. The method may yet further comprise forming a common gate in the IMD layer between the lower source and drain contacts and between the upper source and drain contacts. The common gate may be configured to apply a common voltage to the lower and upper channel structures.

Other features and advantages associated with the apparatus and methods disclosed herein will be apparent to those skilled in the art based on the accompanying drawings and detailed description.

### BRIEF DESCRIPTION OF THE DRAWINGS

A more complete appreciation of aspects of the disclosure and many of the attendant advantages thereof will be readily obtained as the same becomes better understood by reference to the following detailed description when considered in connection with the accompanying drawings which are presented solely for illustration and not limitation of the disclosure.
FIG. 1 illustrates an example of a CFET structure in accordance with one or more aspects of the disclosure.
FIG. 2A illustrates a detailed view of a lower GAA gate region of the example CFET structure of FIG. 1.
FIG. 2B illustrates a detailed view of an upper GAA gate region of the example CFET structure of FIG. 1.
FIG. 3 illustrates an example of a CFET structure formed as a NAND logic in accordance with one or more aspects of the disclosure.
FIG. 4 illustrates an example of a CFET structure formed as a NOR logic in accordance with one or more aspects of the disclosure.
FIG. 5 illustrates another example of a CFET structure in accordance with one or more aspects of the disclosure.
FIG. 6A illustrates a detailed view of a lower GAA gate region of the example CFET structure of FIG. 5.
FIG. 6B illustrates a detailed view of an upper GAA gate region of the example CFET structure of FIG. 5.
FIG. 7 illustrates an example of a CFET structure formed as a NAND logic in accordance with one or more aspects of the disclosure.
FIG. 8 illustrates an example of a CFET structure formed as a NOR logic in accordance with one or more aspects of the disclosure.
FIGS. 9A-9J illustrate examples of stages of fabricating a CFET in accordance with one or more aspects of the disclosure.
FIGS. 10A-10J illustrate other examples of stages of fabricating a CFET in accordance with one or more aspects of the disclosure.
FIGS. 11-15 illustrate flow charts of an example method of manufacturing a CFET in accordance with at one or more aspects of the disclosure.
FIG. 16 illustrates various electronic devices which may utilize one or more aspects of the disclosure.

Other objects and advantages associated with the aspects disclosed herein will be apparent to those skilled in the art based on the accompanying drawings and detailed description. In accordance with common practice, the features depicted by the drawings may not be drawn to scale. Accordingly, the dimensions of the depicted features may be arbitrarily expanded or reduced for clarity. In accordance with common practice, some of the drawings are simplified for clarity. Thus, the drawings may not depict all components of a particular apparatus or method. Further, like reference numerals denote like features throughout the specification and figures.

### DETAILED DESCRIPTION

Aspects of the present disclosure are illustrated in the following description and related drawings directed to specific embodiments. Alternate aspects or embodiments may be devised without departing from the scope of the teachings herein. Additionally, well-known elements of the illustrative embodiments herein may not be described in detail or may be omitted so as not to obscure the relevant details of the teachings in the present disclosure.

In certain described example implementations, instances are identified where various component structures and portions of operations can be taken from known, conventional techniques, and then arranged in accordance with one or more exemplary embodiments. In such instances, internal details of the known, conventional component structures and/or portions of operations may be omitted to help avoid potential obfuscation of the concepts illustrated in the illustrative embodiments disclosed herein.

The terminology used herein is for the purpose of describing particular embodiments only and is not intended to be limiting. As used herein, the singular forms "a," "an," and "the" are intended to include the plural forms as well, unless the context clearly indicates otherwise. It will be further understood that the terms "comprises," "comprising," "includes," and/or "including," when used herein, specify the presence of stated features, integers, steps, operations, elements, and/or components, but do not preclude the presence or addition of one or more other features, integers, steps, operations, elements, components, and/or groups thereof.

As indicated above, transistor scaling beyond FinFET and nanowires - e.g., down to single digit nanometers - is a challenge. In this regard, it is proposed to fabricate transistors using two dimensional (2D) materials for transistor fabrication. The 2D-materials may also be referred to as transition metal dichalcogenide (TMD) having a MX₂ as a generic molecular formula. Here, 'M' designates a transition metal (e.g., titanium (Ti), molybdenum(Mo), tungsten (W), etc.) and 'X' designates a chalgogen (e.g., sulfue (S), selenium (Se), tellurium (Te), etc.). Thus, examples of TMDs include molybdenum disulfide (MoS₂), tungsten disulfide (WS₂) and tungsten diselenide (WSe₂). Note that there can be well over 1500 different combinations of MX₂ TMDs.

In one or more aspects, it is proposed to stack the 2D TMDs to arrive at a 3D transistor configuration. Relative to transistors with silicon (Si) based channels between source and drain, technical advantages of 2D stacked TMDs as transistors include better drive current and lower switching capacitance. In short, 2D enables scaling resulting in better performance and lower energy.

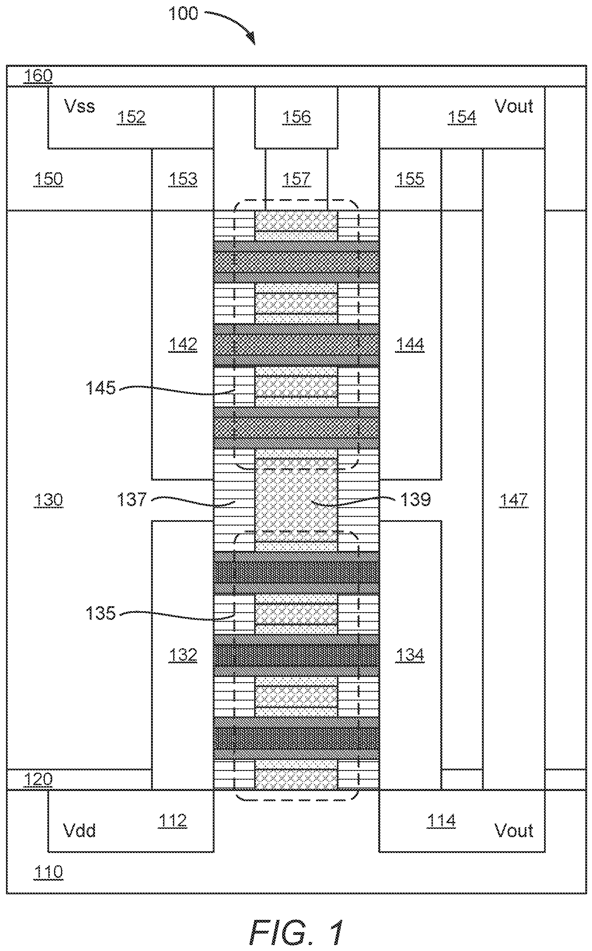

FIG. 1 illustrates an example of a complementary field effect transistor (CFET) structure 100 using gate-all-around (GAA) TMD channels. In this instance, the CFET structure 100 is configured as an inverter (NOT logic). But as will be seen further below, the CFET structures may be configured for other purposes. It is envisioned that the proposed 3D GAA TMDs channel CFET integration may be a roadmap for future technology shrink below one 1 nm.

In FIG. 1, the proposed CFET structure 100 may be formed in multiple intermetal dielectric (IMD) layers. Here, 130 represents the main IMD layer - layer (x), 110 represents an IMD (x-1), and 150 represents IMD layer (x+1). For ease of description, the main IMD layer 130 may simply be referred to as "IMD layer". As seen, the IMD layers 110 and 150 may respectively be below and above the IMD layer 130. Hence, also for ease of description, layer 110 may be referred to as the "lower IMD layer" and layer 150 may be referred to as the "upper IMD layer". It should be noted that there may be other IMD layers below the lower IMD layer 110 and/or above the upper IMD layer 150.

Before proceeding further, the following should also be recognized. Terms such as "above", "below", "left", "right", and so on are terms used for convenience of description. Thus, unless explicitly indicated otherwise, such terms are not meant to limit aspects to a specific direction or orientation.

Within the IMD layer 130, a lower and an upper transistors may be formed. The lower transistor may comprise a lower source contact 132, a lower drain contact 134, and a lower GAA gate region 135, and the upper transistor may comprise an upper source contact 142, an upper drain contact 144, and an upper GAA gate region 145. In an aspect, the lower GAA gate region 135 may be of a first conductivity type (e.g., P-type), and the upper GAA gate region 145 may be of a second conductivity type (e.g., N-type), which is opposite the first conductivity type. Hence, the lower and upper transistors may form complementary transistors. Details of the lower and upper GAA gate regions 135, 145 will be described further below.

The lower and upper source and drain contacts 132, 134, 142, 144 may be conductive. In an aspect, these contacts 132, 134, 142, 144 may be formed from materials including palladium (Pd), nickel (Ni), gold (Au), tungsten (W), tantalum (Ta), tantalum nitride (TaN), titanium (Ti), titanium nitride (TiN), bismuth (Bi), antimony (Sb), molybdenum (Mo), ruthenium (Ru), among others. Each contact 132, 134, 142, 144 may be formed from any combination of such materials. Also, it is not required that all of the contacts 132, 134, 142, 144 be made the same. That is, each of the contacts 132, 134, 142, 144 may be formed materials independent of other contacts 132, 134, 142, 144.

A common gate 139 and spacers 137 may be formed in the IMD layer 130. The common gate 139 may be between the between the lower source and drain contacts 132, 134 and between the upper source and drain contacts 142, 144. The common gate 139 may be electrically conductive. For example, the common gate 139 may be formed from metals such as tungsten (W), titanium nitride (TiN), etc. On the other hand, the spacers 137 may be electrically insulative, e.g., may be formed from oxides, silicon nitride, alumina oxide, etc.

For ease of reference, the spacer 137 left of the common gate 139 (between the upper source contact 142 and the common gate 139 and also between the lower source contact 132 and the common gate 139) may be referred to as the source spacer. Conversely, the spacer 137 right of the common gate 1329 (between the upper drain contact 144 and the common gate 139 and also between the lower drain contact 134 and the common gate 139) may be referred to as the drain spacer. In an aspect, the source spacer may be in contact with any of the common gate 139, the lower source contact 132, and/or the upper source contact 142. Similarly, the drain spacer may be in contact with any of the common gate 139, the lower drain contact 134, and/or the upper drain contact 144. In another aspect, the common gate 139 and/or the spacers 137 may vertically span an entire height of the IMD layer 130, i.e., from an upper surface to a lower surface of the IMD layer 130.

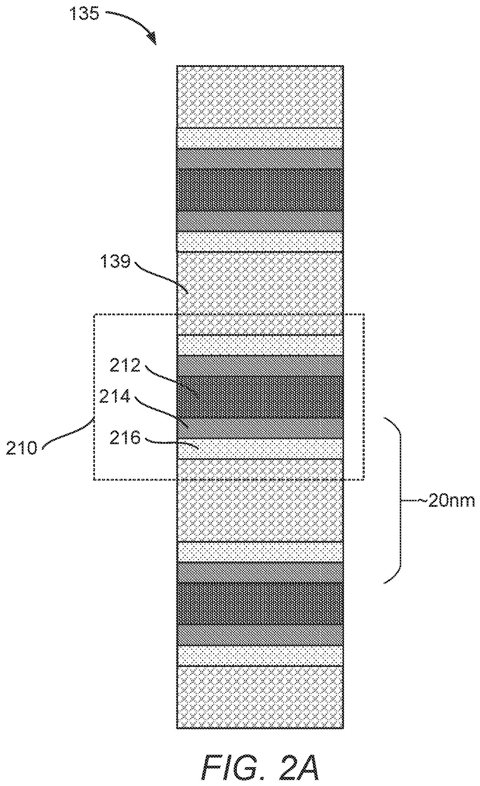

FIG. 2A illustrates an example embodiment of the lower GAA gate region 135. As seen, the lower GAA gate region 135 may include one or more lower channel structures 210 spaced apart from each other. Each lower channel structures 210 may comprise a lower TMD channel 212. In an aspect, the lower TMD channel 212 may be a 2D-material described above. For example, the lower TMD channel 212 may be formed from tungsten diselenide (WSe₂). The lower TMD channel 212 may be very thin. As an example, the lower TMD channel 212 may be formed from one or two layers of the 2D-material (e.g., one or two layers of WSe₂). The thickness of the lower TMD channel 212 may range between 1 and 2nm. Also, adjacent lower TMD channels 212 may be spaced apart from each other by about ~10-20nm.

Gate oxide layers 214 may be formed on both lower and upper surfaces of the lower TMD channel 212. In an aspect, the gate oxide layers 214 may physically contact the lower and/or the upper surfaces of the lower TMD channel 212. For ease of reference, the gate oxide layer 214 on the lower and upper surfaces of the lower TMD channel 212 may respectively be referred to as "first lower gate oxide layer" and "second lower gate oxide layer". The first and/or the second lower gate oxide layers 214 may be high-k dielectric layers. Each gate oxide layer 214 may be a combination of hafnium oxide (HfO₂) and aluminum oxide (Al₂O₃) or a combination of hafnium (Hf), HfO₂, and Al₂O₃. The thickness of each gate oxide layer 214 may range between 2 and 5nm.

Work function layers 216 may also be formed below and above the lower TMD channel 212, e.g., below the first lower gate oxide layer and above the second lower gate oxide layer. In an aspect, the work function layers 216 may physically contact the lower surface of the first lower gate oxide layer and/or the upper surface of the second lower gate oxide layer. For ease of reference, the work function layer 216 on the lower surface of the first lower gate oxide layer may be referred to as "first lower work function layer" and the work function layer 216 on the upper surface of the second lower gate oxide layer may be referred to as "second lower work function layer". The work function layer 216 may be formed from metal, such as TiN, titanium alumina (TiAl), or both. The thickness of each work function layer 216 may range between 1 and 2nm.

In an aspect, adjacent lower channel structures 210 may be spaced apart from each other by about 2 to 5nm. This represents the thickness of the common gate 139 visible in FIG. 2A between the adjacent lower channel structures 210.

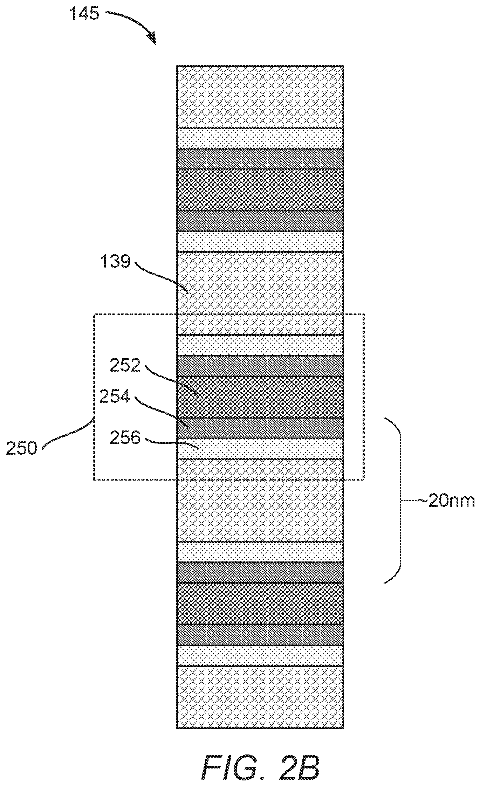

FIG. 2B illustrates an example embodiment of the upper GAA gate region 145. As seen, the upper GAA gate region 145 may include one or more upper channel structures 250 spaced apart from each other. Each upper channel structures 250 may comprise an upper TMD channel 252. The upper TMD channel 252 may also be a 2D-material described above. For example, the upper TMD channel 252 may be formed from molybdenum disulfide (MoS₂). The upper TMD channel 252 may be very thin. As an example, the upper TMD channel 252 may be formed from one or two layers of the 2D-material (e.g., one or two layers of MoS₂). The thickness of the upper TMD channel 252 may range between 1 and 2nm. Also, adjacent upper TMD channels 212 may be spaced apart from each other by about ~10-20nm.

Gate oxide layers 254 may be formed on both upper and upper surfaces of the upper TMD channel 252. In an aspect, the gate oxide layers 254 may physically contact the upper and/or the upper surfaces of the upper TMD channel 252. For ease of reference, the gate oxide layer 254 on the lower and upper surfaces of the upper TMD channel 252 may respectively be referred to as "first upper gate oxide layer" and "second upper gate oxide layer". The first and/or the second upper gate oxide layers 254 may be high-k dielectric layers. Each gate oxide layer 254 may be a combination of hafnium oxide (HfO₂) and aluminum oxide (Al₂O₃) or a combination of hafnium (Hf), HfO₂, and Al₂O₃. The thickness of each gate oxide layer 254 may range between 2 and 5nm.

Work function layers 256 may also be formed below and above the upper TMD channel 252, e.g., below the first upper gate oxide layer and above the second upper gate oxide layer. In an aspect, the work function layers 256 may physically contact the lower surface of the first upper gate oxide layer and/or the upper surface of the second upper gate oxide layer. For ease of reference, the work function layer 256 on the lower surface of the first upper gate oxide layer may be referred to as "first upper work function layer" and the work function layer 256 on the upper surface of the second upper gate oxide layer may be referred to as "second upper work function layer". The work function layer 256 may be formed from metal, such as TiN. The thickness of each work function layer 256 may range between 1 and 2nm.

In an aspect, adjacent upper channel structures 250 may be spaced apart from each other by about 2 to 5nm. This represents the thickness of the common gate 139 visible in FIG. 2B between the adjacent upper channel structures 250.

Referring back to FIG. 1, note that the lower TMD channels 212 (not numbered in FIG. 1) may be electrically coupled with the lower source contact 132 and with the lower drain contact 134. For example, the lower TMD channels 212 may be in physical contact with the lower source and drain contacts 132, 134. Similarly, the upper TMD channels 252 (not numbered in FIG. 1) may be electrically coupled with the upper source contact 142 and with the upper drain contact 144. For example, the upper TMD channels 252 may be in physical contact with the upper source and drain contacts 142, 144.

The common gate 139 may be configured to apply a common voltage to the lower and upper channel structures 210, 250 to induce conductive paths in the lower TMD channels 212 between the lower source and drain contacts 132, 134 and to induce conductive paths in the upper TMD channels 252 between the upper source and drain contacts 142, 144. In an aspect, upper surfaces of the upper source contact 142, the spacers 137, and common gate 139, and the upper drain contact 144 may be planar with the upper surface of the IMD layer 130.

The CFET structure 100 may include a lower source terminal 112 and a lower drain terminal 114 in the lower IMD layer 110. The lower source terminal 112 and/or the lower drain terminal 114 may be formed form conductive materials such as highly doped silicon and metals (e.g., copper (Cu)). The lower source terminal 112 and/or the lower drain terminal 114 may be exposed at an upper surface of the lower IMD layer 110. For example, upper surfaces of the terminals 112, 114 and the lower IMD layer 110 may be planar. The lower source terminal 112 may be electrically coupled with the lower source contact 132 and the lower drain terminal 114 may be electrically coupled with the lower drain contact 134. For example, the lower source terminal 112 may physically contact the lower source contact 132 and/or the lower drain terminal 114 may physically contact the lower drain contact 134.

The CFET structure 100 may include an upper source terminal 152, an upper drain terminal 154, and an upper gate terminal 156 in the upper IMD layer 150. The upper source terminal 152, the upper drain terminal 154, and/or the upper gate terminal 156 may be formed form conductive materials such as highly doped silicon and metals (e.g., copper (Cu)). The upper source terminal 152, the upper drain terminal 154, and/or the upper gate terminal 156 may be exposed at an upper surface of the upper IMD layer 150. For example, upper surfaces of the terminals 152, 154, 156 and the upper IMD layer 150 may be planar.

The upper source terminal 152, the upper drain terminal 154, and the upper gate terminal 156 may be electrically coupled with the upper source contact 142, the upper drain contact 144, and common gate 139. In an aspect, a source via 153 may be formed in the upper IMD layer 150 to electrically couple the upper source terminal 152 with the upper source contact 142. Alternatively or in addition thereto, a drain via 155 may be formed in the upper IMD layer 150 to electrically couple the upper drain terminal 154 with the upper drain contact 144. Still alternatively or in addition there to, a drain via 155 may be formed in the upper IMD layer 150 to electrically couple the upper drain terminal 154 with the upper drain contact 144. When present, lower surfaces of the source, the drain, and gate vias 153, 155, 157 may be planar with the lower surface of the upper IMD layer 150.

In an aspect, the CFET structure 100 may include a lower protection layer 120 and an upper protection layer 160. The lower protection layer 120 may be between the lower IMD layer 110 and the IMD layer 130, and the upper protection layer 160 may be on a top surface of the upper IMD layer 150. One or both of the lower and upper protections layers 120, 160 may be formed from silicon carbon nitride (SiCN).

Note that the CFET structure 100 of FIG. 1 includes a tail via 147 in the lower IMD layer 110 and in the IMD layer 130. In particular, the tail via 147 electrically couples the lower drain terminal 114 with the upper drain terminal 154 (e.g., may be in physical contact with the lower drain terminal 114 and/or with the upper drain terminal 154). In this configuration, the CFET structure may function as an inverter, i.e., as a NOT logic. That is, the Vout voltage (at the drain terminals 114, 154) may be logically opposite to a voltage applied at the gate 156.

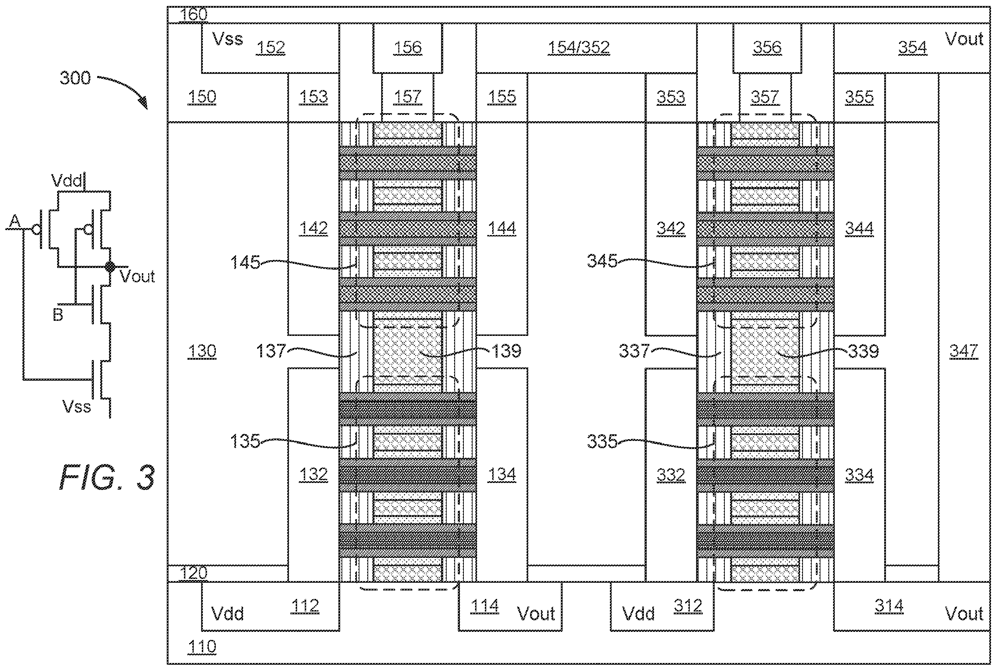

However, the GAA TMDs may be configured in other CFET structures to perform other functions. FIG. 3 illustrates an example C112FET structure 300 configured to perform a two-input NAND logic. As seen, the CFET structure 300 is shown to include the components of the structure in FIG. 1 - the lower source and drain terminals 112, 114 in the lower IMD layer 110; the upper source, drain and gate terminals 152, 154, 156 along with source, drain and gate vias 153, 155, 157 in the upper IMD layer 150; and the lower source and drain contacts 132, 134, the upper source and drain contacts 142, 144, the lower and upper GAA gate regions 135, 145, the spacers 137, and the common gate 139. It may be assumed that the descriptions of these components provided with respect to FIG. 1 may also apply with respect to FIG. 3.

As seen, the CFET structure 300 may also include second spacers 337, a second common gate 339, a second lower source contact 332, a second lower drain contact 334, a second lower GAA gate region 335, a second upper source contact 342, a second upper drain contact 344, and a second upper GAA gate region 345. The formation of the second contacts 332, 334, 342, 344 may be similar to the contacts 132, 134, 142, 144 (e.g., formed from any one or more of Pd, Ni, Au, W, Ta, TaN, Ti, TiN, Bi, Sb, Mo, Ru, among others.

The second lower and upper GAA gate regions 335, 345 may also be similar to the lower and upper GAA gate regions 135, 145. That is, the second lower GAA gate region 335 may be of the first conductivity type and the second upper GAA gate region 335 may be of the second conductivity type (e.g., see FIG. 2B). The second lower GAA gate region 335 may comprise one or more lower channel structures 210 (see FIG. 2A), and the second upper GAA gate region 345 may comprise one or more upper channel structures 250 (see FIG. 2B). For differentiation purposes, the components associated with the second lower and upper GAA gate regions 335, 345 will be prefaced with "second". Thus, each second lower channel structure 210 of the second lower GAA gate region 335 may comprise a second lower TMD channel 212, second-first and second-second lower gate oxide layers 214, and second-first and second-second work function layers 216. Similarly, each second upper channel structure 250 of the second upper GAA gate region 345 may comprise a second upper TMD channel 252, second-first and second-second upper gate oxide layers 254, and second-first and second-second work function layers 256.

In the lower IMD layer 110, a second lower source terminal 312 and a second lower drain terminal 314 may be formed. The second lower source terminal 312 may be electrically coupled with the second lower source contact 332, and the second lower drain terminal 314 may be electrically coupled with the second lower drain contact 334.

In the upper IMD layer 150, a second upper drain terminal 354 and a second upper gate terminal 356 may be formed. The second upper drain terminal 354 may be electrically coupled (e.g., through a second drain via 355) with the second upper drain contact 344. The second upper gate terminal 356 may be electrically coupled (e.g., through a second gate via 357) with the second common gate 339. A second upper source terminal 352 electrically coupled (e.g., through second source via 353) may also be formed. But in an aspect, the second source terminal 352 and the drain terminal 154 may be common, i.e., one and the same.

Note that the tail via 347 electrical couple the second lower drain terminal 314 with the second upper drain terminal 354. In this configuration, the CFET structure 300 may perform a NAND logic of the inputs provided to the upper gate terminal 156 and to the second upper gate terminal 356.

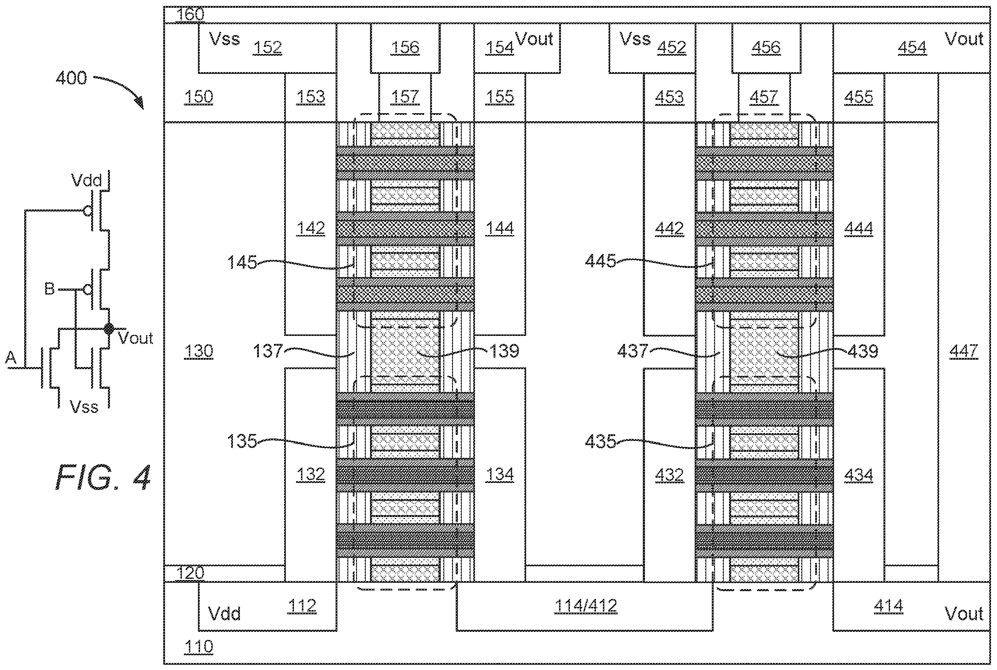

FIG. 4 illustrates an example CFET structure 400 configured to perform a two-input NOR logic. As seen, the CFET structure 400 is shown to include the components of the structure in FIG. 1 - the lower source and drain terminals 112, 114 in the lower IMD layer 110; the upper source, drain and gate terminals 152, 154, 156 along with source, drain and gate vias 153, 155, 157 in the upper IMD layer 150; and the lower source and drain contacts 132, 134, the upper source and drain contacts 142, 144, the lower and upper GAA gate regions 135, 145, the spacers 137, and the common gate 139. It may be assumed that the descriptions of these components provided with respect to FIG. 1 may also apply with respect to FIG. 4.

As seen, the CFET structure 400 may also include third spacers 437, a third common gate 439, a third lower source contact 432, a third lower drain contact 434, a third lower GAA gate region 435, a third upper source contact 442, a third upper drain contact 444, and a third upper GAA gate region 445. The formation of the third contacts 432, 434, 442, 444 may be similar to the contacts 132, 134, 142, 144 (e.g., formed from any one or more of Pd, Ni, Au, W, Ta, TaN, Ti, TiN, Bi, Sb, Mo, Ru, among others.

The third lower and upper GAA gate regions 435, 445 may also be similar to the lower and upper GAA gate regions 135, 145. That is, the third lower GAA gate region 435 may be of the first conductivity type and the third upper GAA gate region 445 may be of the second conductivity type (e.g., see FIG. 2B). The third lower GAA gate region 435 may comprise one or more lower channel structures 210 (see FIG. 2A), and the third upper GAA gate region 445 may comprise one or more upper channel structures 250 (see FIG. 2B). For differentiation purposes, the components associated with the third lower and upper GAA gate regions 435, 445 will be prefaced with "third". Thus, each third lower channel structure 210 of the third lower GAA gate region 435 may comprise a third lower TMD channel 212, third-first and third-second gate oxide layers 214, and third-first and third-second work function layers 216. Similarly, each third upper channel structure 250 of the third upper GAA gate region 445 may comprise a third upper TMD channel 252, third-first and third-second gate oxide layers 254, and third-first and third-first work function layers 256.

In the lower IMD layer 110, a third lower drain terminal 414 electrically coupled with the third lower drain contact 434 may be formed. A third lower source terminal 412 may also be formed. But in an aspect, the lower drain terminal and the third lower source terminal 412 may be common.

In the upper IMD layer 150, a third upper source terminal 452, a third upper drain terminal 454, and a third upper gate terminal 456 may be formed. The third upper source terminal 452 may be electrically coupled (e.g., through a third source via 453) with the third upper source contact 442. The third upper drain terminal 454 may be electrically coupled (e.g., through a third drain via 455) with the third upper drain contact 444. The third upper gate terminal 456 may be electrically coupled (e.g., through a third gate via 457) with the third common gate 439.

Note that the tail via 447 electrical couple the third lower drain terminal 414 with the third upper drain terminal 454. In this configuration, the CFET structure 400 may perform a NOR logic of the inputs provided to the upper gate terminal 156 and to the third upper gate terminal 456.

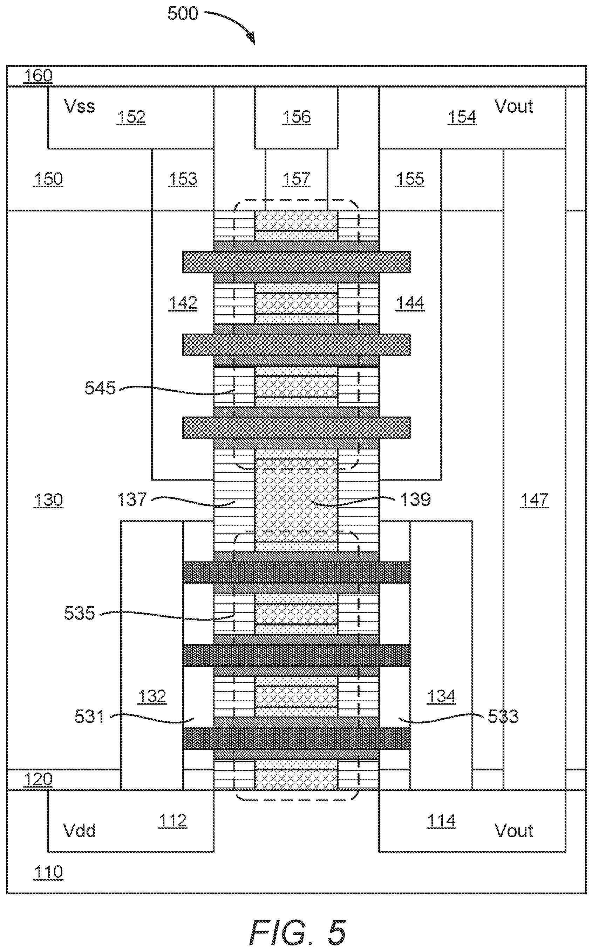

FIG. 5 illustrates another example of a CFET structure 500 in accordance with one or more aspects of the disclosure. The CFET structure 500 the is much like CFET structure 100 of FIG. 1 in that both include many of the same elements. The like numbered elements may be assumed to behave same in both structures. Thus, the differences between FIG. 1 and FIG. 5 will be described.

One difference is that the CFET structure 500 is shown may include a lower GAA gate region 535 and an upper GAA gate region 545 (instead of the lower and upper GAA gate regions 135, 145). The lower GAA gate region 535 may be of a first conductivity type and the upper GAA gate region 545 may be of a second conductivity type opposite the first conductivity type.

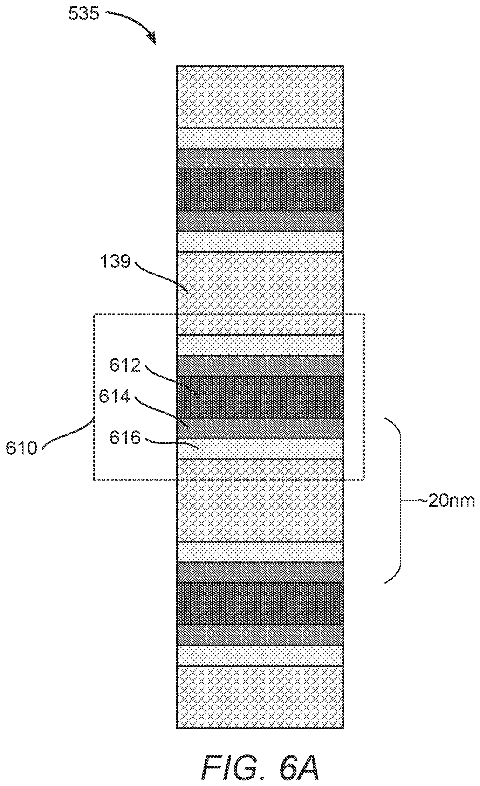

As seen in in FIG. 6A, the lower GAA gate region 535 may include one or more lower channel structures 610. Each lower channel structure 610 may comprise a lower TMD channel 612. The lower TMD channel 612 may be formed from 2D-materials. In an aspect, the lower TMD channel 612 may be formed from one of WSe₂ and MoS₂. The lower TMD channel 612 may be very thin. As an example, the lower TMD channel 612 may be formed from one or two layers of the 2D-material. The thickness of the lower TMD channel 612 may range between 1 and 2nm. Also, adjacent lower TMD channels 612 may be spaced apart from each other by about ~10-20nm.

Each lower channel structure 610 may also include first and second lower gate oxide layers 614 (e.g., below and above the lower TMD channel 612). The first and second lower gate oxide layers 614 may be similar to the first and second lower gate oxide layers 214 of FIG. 2A. Each lower channel structure 610 may further include first and second lower work function layers 616. The first and second lower work function layers 616 may be similar to the first and second lower work function layers 216 of FIG. 2A.

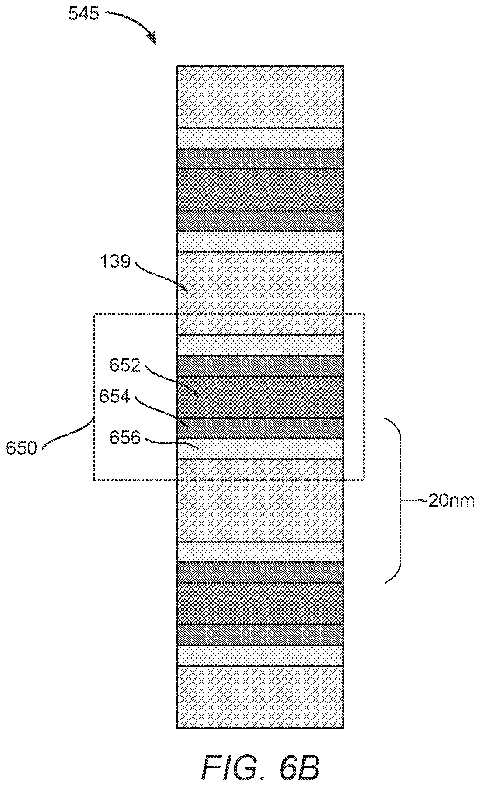

As seen in in FIG. 6B, the upper GAA gate region 545 may include one or more upper channel structures 650. Each upper channel structure 650 may comprise an upper TMD channel 652. The upper TMD channel 652 may be formed from 2D-materials. In an aspect, the upper TMD channel 652 may be formed from the other one of WSe₂ and MoS₂. The upper TMD channel 652 may be very thin. As an example, the upper TMD channel 652 may be formed from one or two layers of the 2D-material. The thickness of the upper TMD channel 652 may range between 1 and 2nm. Also, adjacent upper TMD channels 652 may be spaced apart from each other by about ~10-20nm.

Each upper channel structure 650 may also include first and second upper gate oxide layers 654 (e.g., below and above the upper TMD channel 652). The first and second upper gate oxide layers 654 may be similar to the first and second upper gate oxide layers 214 of FIG. 2A. Each upper channel structure 650 may further include first and second upper work function layers 656. The first and second upper work function layers 656 may be similar to the first and second upper work function layers 216 of FIG. 2B.

Referring back to FIG. 5, another difference is that the CFET structure 500 may also include a lower inner source contact 531 and a lower outer drain contact 533. The lower inner source contact 531 may be between the lower source contact 132 and the lower GAA gate region 535, and the lower inner drain contact 533 may be between the lower GAA gate region 535 and the lower drain contact 134. The lower inner source and drain contacts 531, 533 may be conductive. In an aspect, the contacts 531, 533 may me formed from materials similar to those of contacts 132, 134. The lower source contact 132 may be shifted to the left so as to be laterally outside of the upper source contact 142. Alternatively or in addition thereto, the lower drain contact 134 may be shifted to the right so as to be laterally outside of the upper drain contact 144.

Note that the lower source contact 132 may be electrically coupled with the lower TMD channels 612 (not numbered in FIG. 5), e.g., through the lower inner source contact 531. Also, the lower drain contact 134 may be electrically coupled with the lower TMD channels 612, e.g., through the lower inner drain contact 533. In an aspect, the lower inner source contact 531 may physically contact the lower source contact 132 and the lower TMD channels 612. Alternatively or in addition thereto, the lower inner drain contact 533 may physically contact the lower drain contact 134 and the lower TMD channels 612.

As seen, the lower TMD channels 612 may extend into the lower inner source contact 531 and/or into the lower inner drain contact 533. Alternatively or in addition thereto, the lower TMD channels 612 may also extend into the lower source contact 132 and/or into the lower drain contact 134. Further alternatively or in addition thereto, the upper TMD channels 652 (not numbered in FIG. 5) may extend into the upper source and/or drain contacts 142, 144. When the lower and/or upper TMD chnnels 612, 652 extend into the contacts 132, 531, 134, 532, 432, 434, the contact area is increased. This can reduce the contact resistance, which is beneficial.

The CFET structure 500 includes tail via 147 in the lower IMD layer 110 and in the IMD layer 130. Thus, like the CFET structure 100 (of FIG. 1), the CFET structure 500 is also configured to perform a NOT logic.

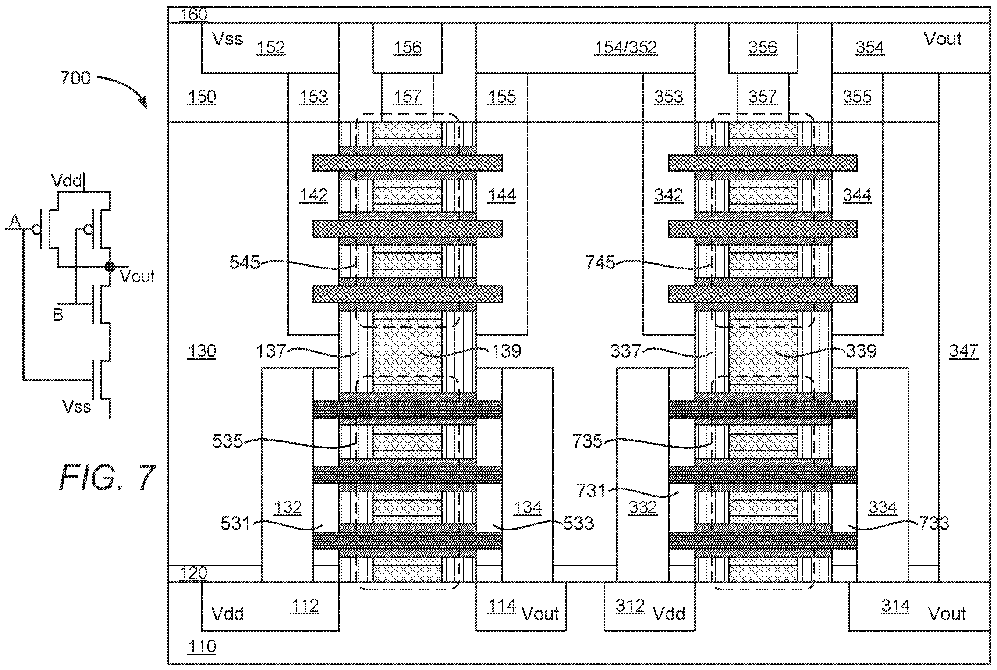

FIG. 7 illustrates a CFET structure 700 configured to perform a NAND logic like the CFET structure 300 (of FIG. 3). The following are some of the differences between FIGS. 3 and 7. First, the CFET structure 700 can include the lower inner source contact 531, the lower inner drain contact 533, the second lower inner source contact 731, and the second lower inner drain contact 733. Also, the second lower TMD channels 612 (not numbered in FIG. 7) may respectively extend into the second lower inner source contact 731 and/or into the second lower inner drain contact 733. Further, the second upper TMD channels 616 (not numbered in FIG. 7) may respectively extend into the second upper source contact 342 and/or into the second upper drain contact 344. Note that the CFET structure 700 may include second lower and upper GAA gate regions 735, 745.

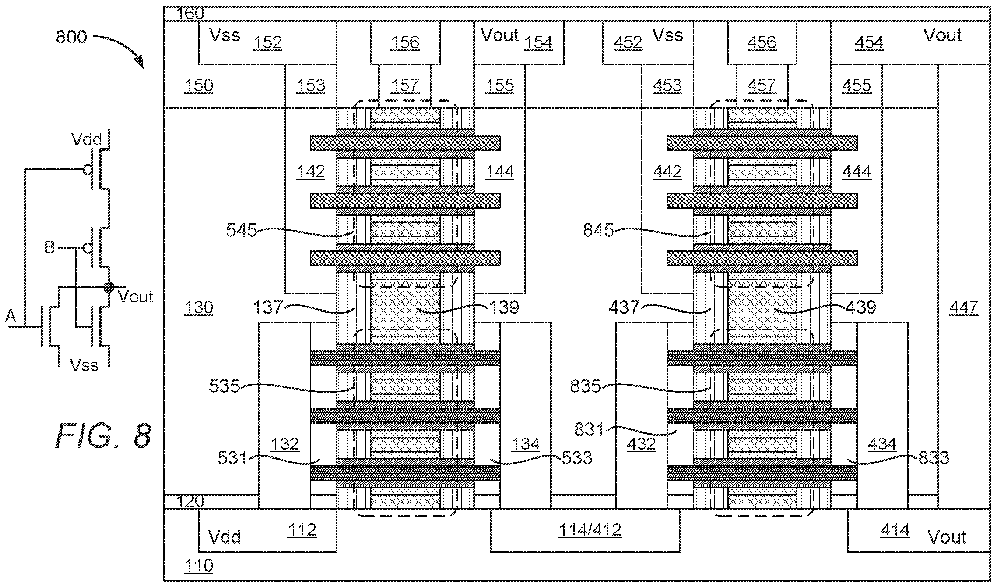

FIG. 8 illustrates a CFET structure 800 configured to perform a NOR logic like the CFET structure 400 (of FIG. 4). The following are some of the differences between FIGS. 4 and 8. First, the CFET structure 800 can include the lower inner source contact 531, the lower inner drain contact 533, the third lower inner source contact 831, and the third lower inner drain contact 833. Also, the third lower TMD channels 612 (not numbered in FIG. 8) may respectively extend into the third lower inner source contact 831 and/or into the third lower inner drain contact 833. Further, the third upper TMD channels 616 (not numbered in FIG. 8) may respectively extend into the third upper source contact 442 and/or into the third upper drain contact 444. Note that the CFET structure 800 may include third lower and upper GAA gate regions 835, 845.

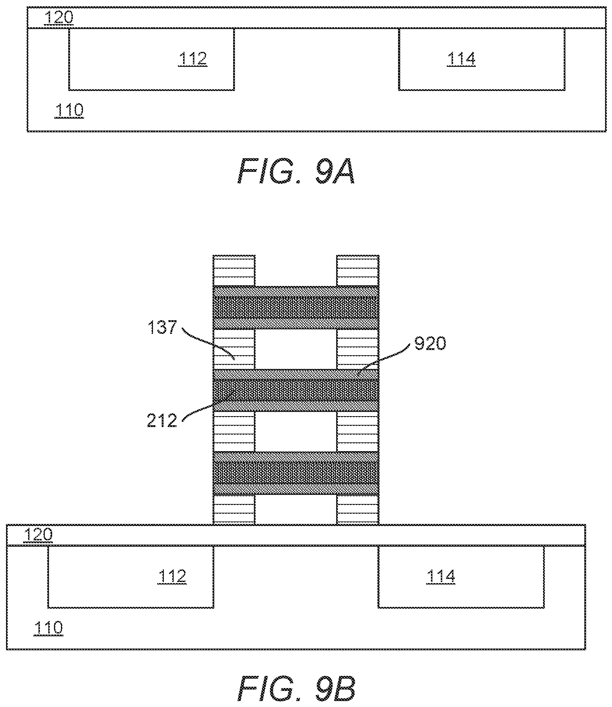

FIGS. 9A-9J illustrate examples of stages of fabricating a CFET structure - such as the CFET structures 100, 300, 400 - in accordance with one or more aspects of the disclosure.

FIG. 9A illustrates a stage in which fabrication starts from a back-end-of-line (BEOL) IMD layer (x-1) - i.e., the lower IMD layer 110. Here, metal layer x-1 may be deposited and patterned to form the lower source terminal 112 and the lower drain terminal 114. The lower protection layer 120 may be formed on the lower IMD layer 110 by depositing and patterning (e.g., polishing) protection material (e.g., SiCn).

FIG. 9B illustrates a stage in which multiple oxide/ HfO₂/2D film (e.g., WSe₂) layers are deposited for first conductivity type transistor (e.g., P-type). The active and oxide films may be patterned at the gate area while keeping the 2D film materials. Spacer material (e.g., SiN) may be deposited and etched to form the spacers 137. In short, the lower TMD channels 212 and HfO₂ layers 920 (which is temporary) may be formed. Note that the spacers 137 are partial at this stage.

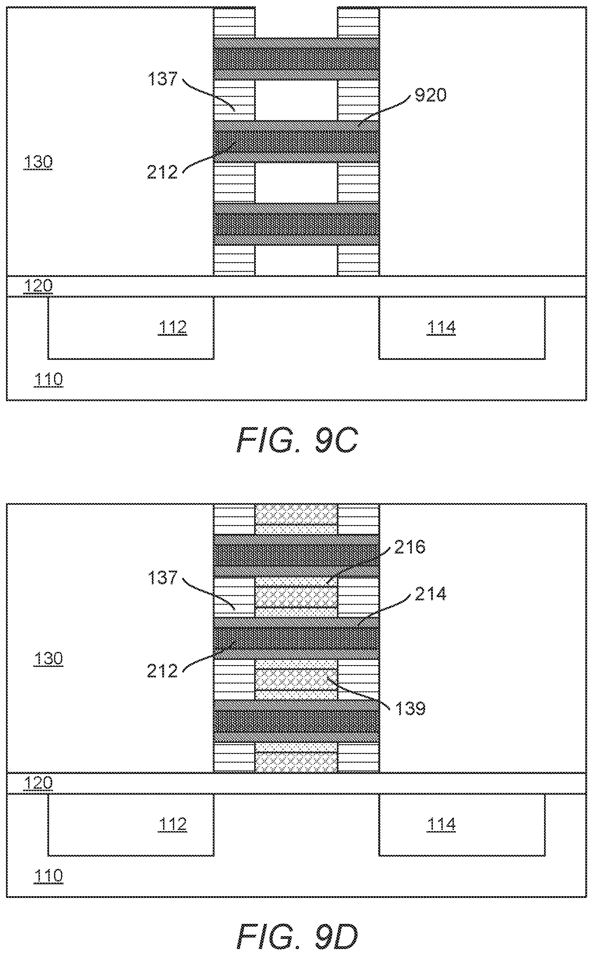

FIG. 9C illustrates a stage in which an IMD oxide material may be deposited and planarized (e.g., through chemical-mechanical polishing (CMP)) to form the IMD layer 130. The gate area may be opened and the oxide in the gate area may be removed. The IMD layer 130 is partial at this stage.

FIG. 9D illustrates a stage in which previous HfO₂ layers 920 are removed. Then HfO₂/Al₂O₃ or Hf/ HfO₂/Al₂O₃ may be deposited (e.g., through atomic layer deposition (ALD)) to form the lower gate oxide layers 214. The lower working function layers 216 may be formed (e.g., by ALD deposition of TiN). Also, common gate 139 may be formed (e.g., by depositing W and polishing). Note that the common gate 139 is partial at this stage.

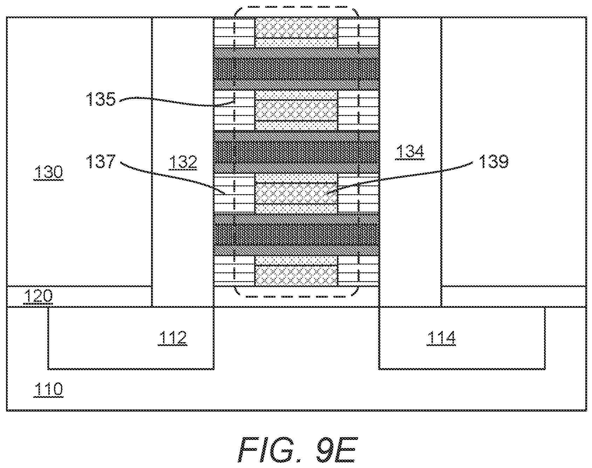

FIG. 9E illustrates a stage in which the lower GAA gate region 135 is formed. Here, the lower source and drain contacts 132, 134 may be formed by patterning the IMD layer 130 and the lower protection layer 120 and depositing conductive materials (e.g., Pd, Ni, Au, W, Ta, TaN, Ti, TiN, Bi, Sb, Mo, Ru, etc.) in the patterned area. The deposited materials may then be polished (e.g., CMP).

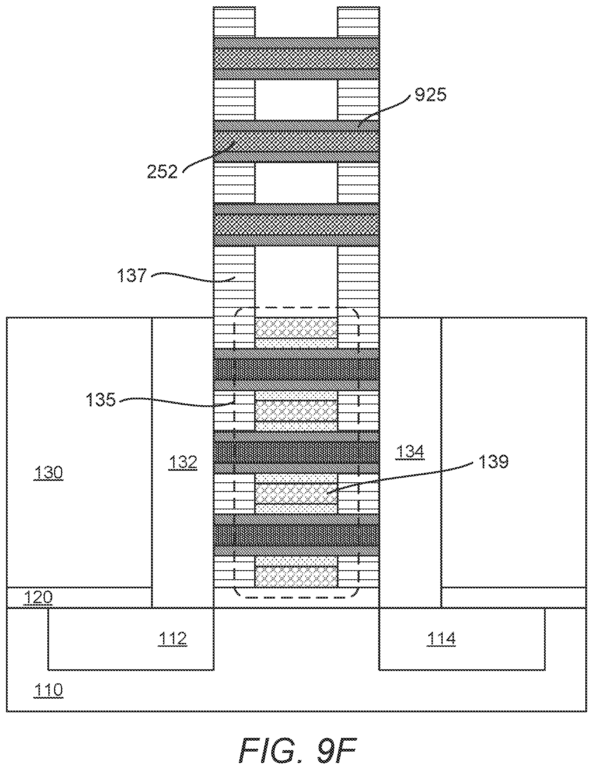

FIG. 9F illustrates a stage in which multiple oxide/HfO₂/2D film (e.g., MoS₂) layers are deposited for second conductivity type transistor (e.g., N-type). The active and oxide films may be patterned at the gate area while keeping the 2D film materials. Spacer material (e.g., SiN) may be deposited and etched to further form the spacers 137. In short, the upper TMD channels 252 and HfO₂ layers 925 (which is temporary) may be formed. Note that the spacers 137 may be at full height at this stage.

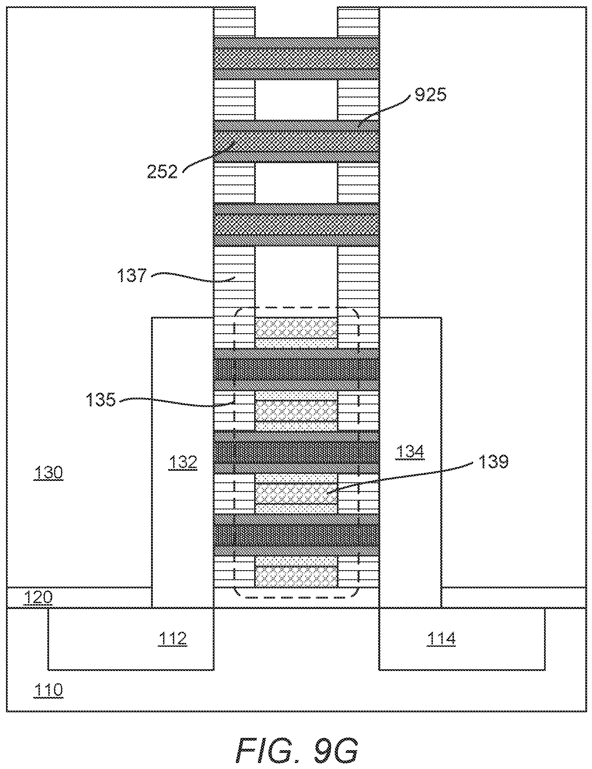

FIG. 9G illustrates a stage in which more IMD oxide may be deposited and planarized (e.g., through CMP) to further form the IMD layer 130. The gate area may be opened and the oxide in the gate area may be removed. The IMD layer 130 may be at full height at this stage.

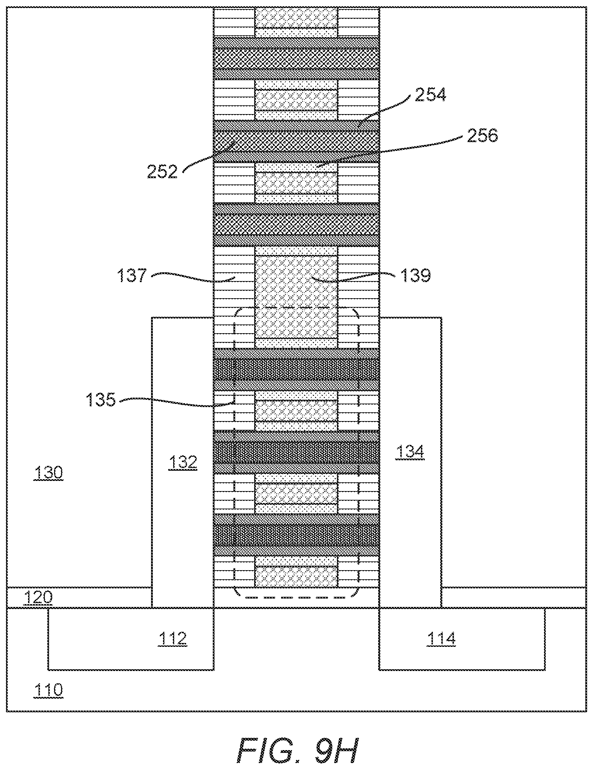

FIG. 9H illustrates a stage in which illustrates a stage in which previous HfO₂ layers 925 are removed. Then HfO₂/Al₂O₃ or Hf/ HfO₂/Al₂O₃ may be deposited (e.g., through ALD) to form the upper gate oxide layers 254. The upper working function layers 256 may be formed (e.g., by ALD deposition of TiN). Also, common gate 139 may be further formed (e.g., by depositing W and polishing). Note that the common gate 139 can at full height at this stage.

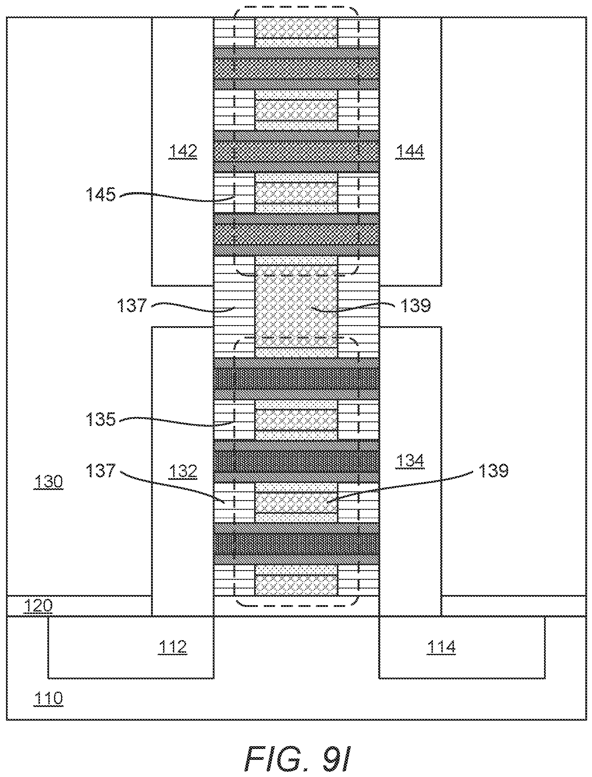

FIG. 9I illustrates a stage in which the upper GAA gate region 145 is formed. Here, the areas for the upper source and drain contacts 142, 144 may be patterned in the IMD layer 130. The patterned areas may be deposited with conductive materials (e.g., Pd, Ni, Au, W, Ta, TaN, Ti, TiN, Bi, Sb, Mo, Ru, etc.) and polished (e.g., CMP).

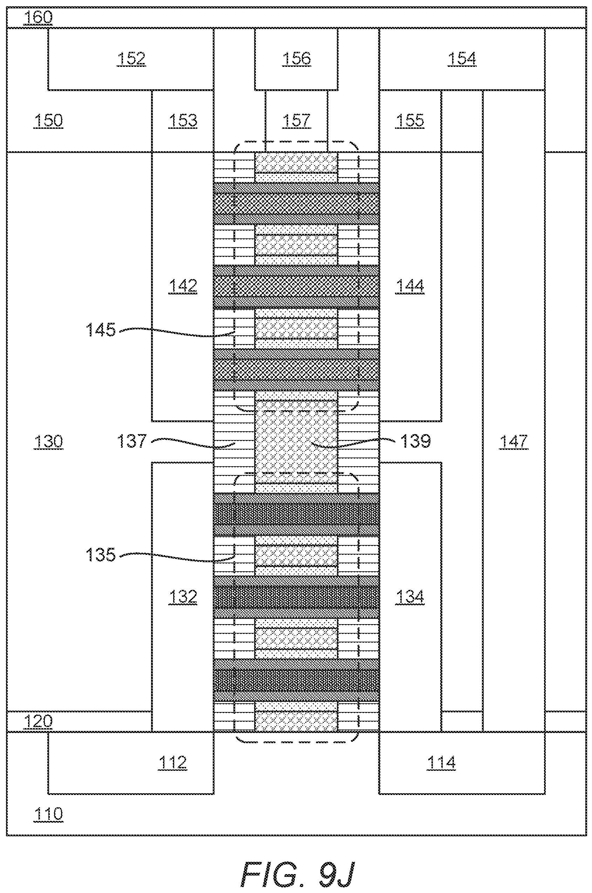

FIG. 9J illustrates a stage in which more IMD oxide layer may be deposited and patterned to form the upper IMD layer 150. Here, metal layer x+1 may be deposited and patterned to form the upper source terminal 152, upper drain terminal 154, and the upper gate terminal 156. The source, drain, and gate vias 153, 155, 157 may also be formed. Further, the lower protection layer 120, the IMD layer 130, and the upper IMD layer 150 may be patterned, and conductive material may be deposited in the patterned area to form the tail via 147. The upper protection layer 160 may be formed on the upper IMD layer 150 by depositing and patterning (e.g., polishing) protection material (e.g., SiCN).

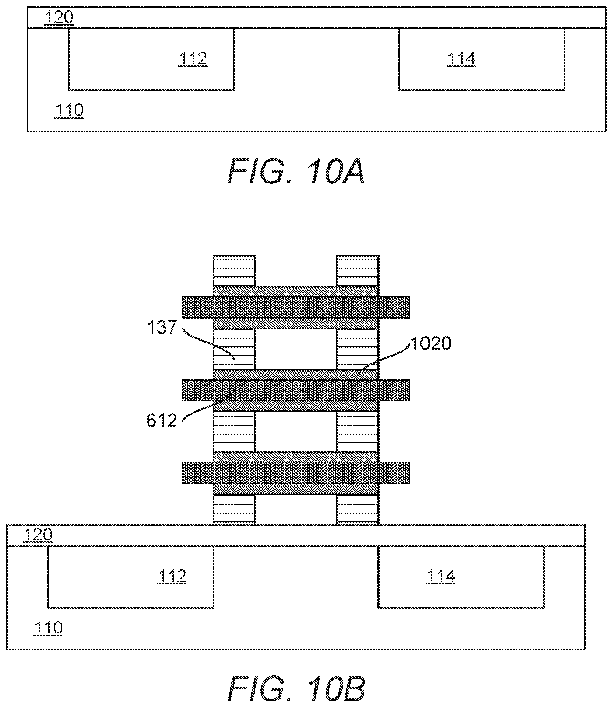

FIGS. 10A-10J illustrate examples of stages of fabricating a CFET structure - such as the CFET structures 500, 700, 800 - in accordance with one or more aspects of the disclosure.

FIG. 10A illustrates a stage in which fabrication starts from a back-end-of-line (BEOL) IMD layer (x-1) - i.e., the lower IMD layer 110. Here, metal layer x-1 may be deposited and patterned to form the lower source terminal 112 and the lower drain terminal 114. The lower protection layer 120 may be formed on the lower IMD layer 110 by depositing and patterning (e.g., polishing) protection material (e.g., SiCN).

FIG. 10B illustrates a stage in which multiple oxide/ HfO₂/2D film (e.g., one of MoS₂ and WSe₂) layers are deposited for first conductivity type transistor (e.g., P-type). The active and oxide films may be patterned at the gate area while keeping the 2D film materials. Spacer material (e.g., SiN) may be deposited and etched to form the spacers 137. In short, the lower TMD channels 612 and HfO₂ layers 1020 (which is temporary) may be formed. Note that the lower TMD channels 612 are wider than the lower TMD channels 212 (of FIG. 9B). For example, the lower TMD channels 612 may extend beyond the spacers 137. Also note that the spacers 137 are partial at this stage.

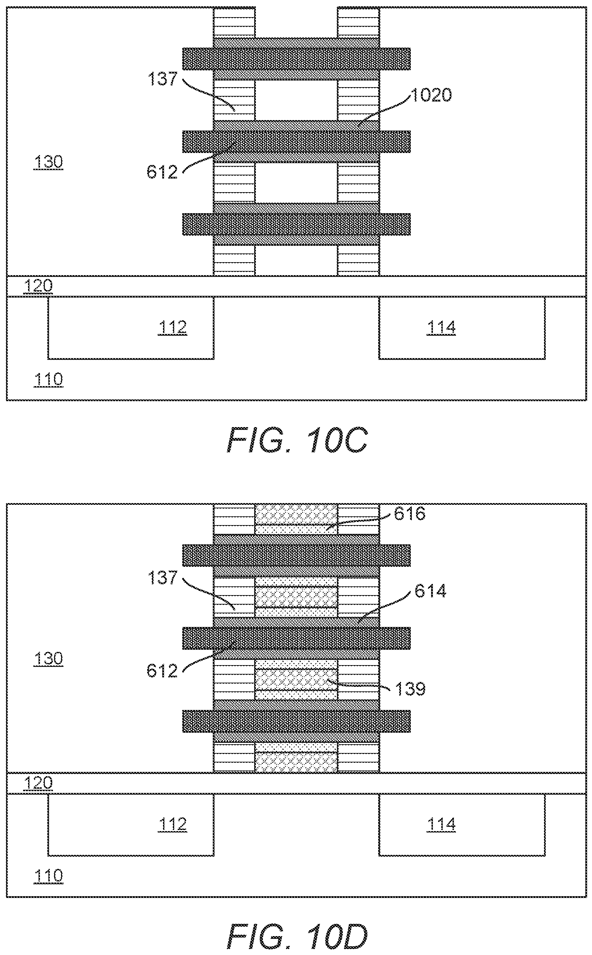

FIG. 10C illustrates a stage in which an IMD oxide material may be deposited and planarized (e.g., through (CMP) to form the IMD layer 130. The gate area may be opened and the oxide in the gate area may be removed. The IMD layer 130 is partial at this stage.

FIG. 10D illustrates a stage in which previous HfO₂ layers 1020 are removed. Then HfO₂/Al₂O₃ or Hf/ HfO₂/Al₂O₃ may be deposited (e.g., through ALD) to form the lower gate oxide layers 614. The lower working function layers 616 may be formed (e.g., by ALD deposition of TiN). Also, common gate 139 may be formed (e.g., by depositing W and polishing). Note that the common gate 139 is partial at this stage.

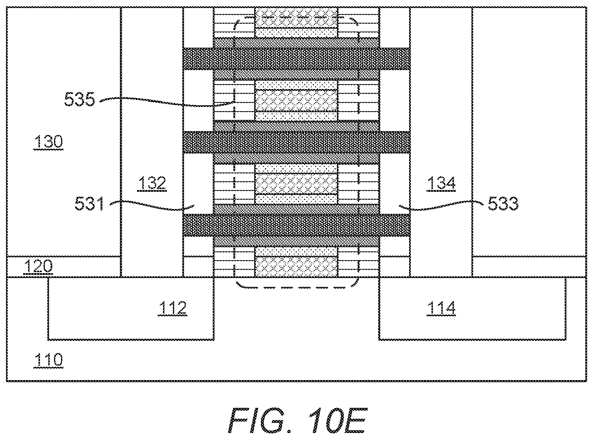

FIG. 10E illustrates a stage in which the lower GAA gate region 535 is formed. Here, the lower inner source and drain contacts 531, 533 may be formed by patterning the IMD layer 130 and depositing conductive materials (e.g., Pd, Ni, Au, W, Ta, TaN, Ti, TiN, Bi, Sb, Mo, Ru, etc.) in the patterned area. Also, the lower source and drain contacts 132, 134 may be formed by patterning the IMD layer 130 and the lower protection layer 120 and depositing conductive materials (e.g., Pd, Ni, Au, W, Ta, TaN, Ti, TiN, Bi, Sb, Mo, Ru, etc.) in the patterned area. The deposited materials for the inner source and drain contacts 531, 533 and for the lower source and drain contacts 132, 134 may be polished (e.g., CMP).

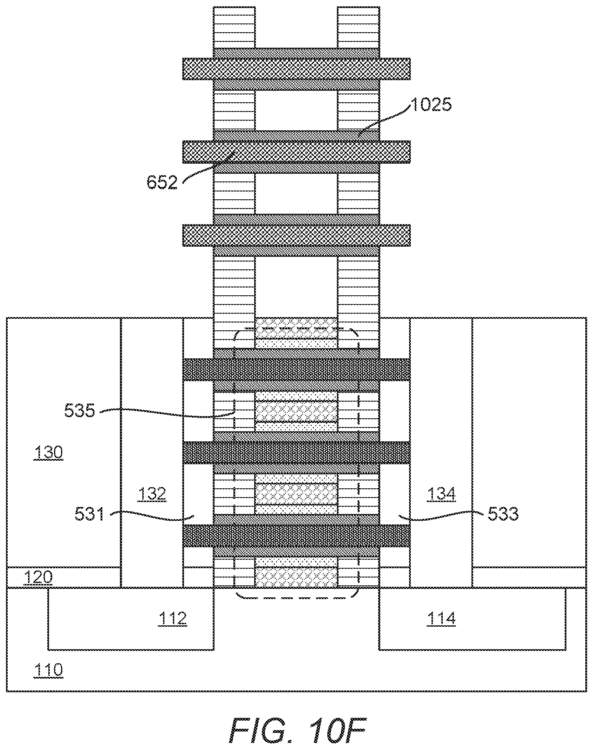

FIG. 10F illustrates a stage in which multiple oxide/ HfO₂/2D film (e.g., MoS₂) layers are deposited for second conductivity type transistor (e.g., N-type). The active and oxide films may be patterned at the gate area while keeping the 2D film materials. Spacer material (e.g., SiN) may be deposited and etched to further form the spacers 137. In short, the upper TMD channels 652 and HfO₂ layers 1025 (which is temporary) may be formed. Note that the spacers 137 may be at full height at this stage.

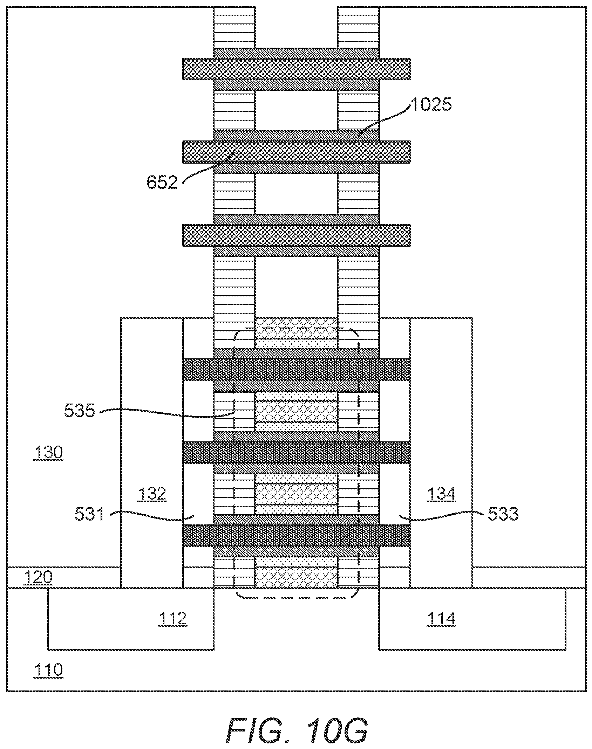

FIG. 10G illustrates a stage in which more IMD oxide may be deposited and planarized (e.g., through CMP) to further form the IMD layer 130. The gate area may be opened and the oxide in the gate area may be removed. The IMD layer 130 may be at full height at this stage.

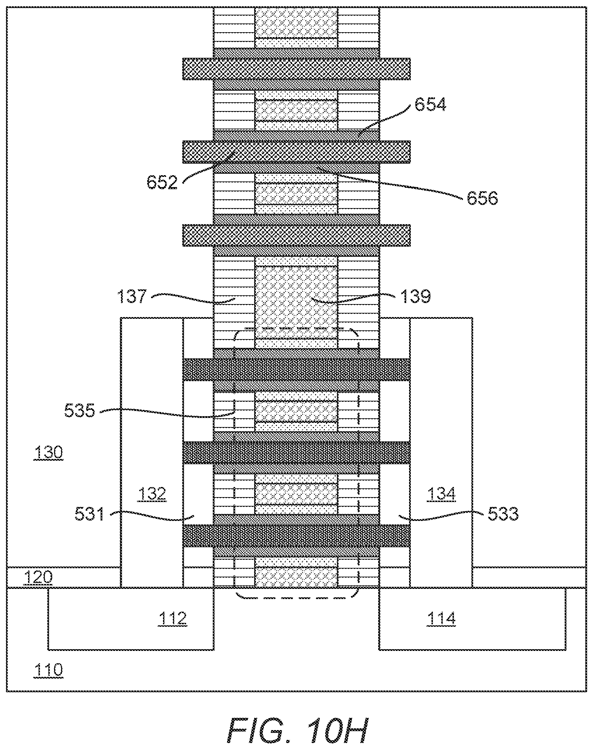

FIG. 10H illustrates a stage in which illustrates a stage in which previous HfO₂ layers 1025 are removed. Then HfO₂/Al₂O₃ or Hf/ HfO₂/Al₂O₃ may be deposited (e.g., through ALD) to form the upper gate oxide layers 654. The upper working function layers 656 may be formed (e.g., by ALD deposition of TiN). Also, common gate 139 may be further formed (e.g., by depositing W and polishing). Note that the upper TMD channels 656 are wider than the upper TMD channels 216 (of FIG. 9H). For example, the upper TMD channels 656 may extend beyond the spacers 137. Also note that the common gate 139 can at full height at this stage.

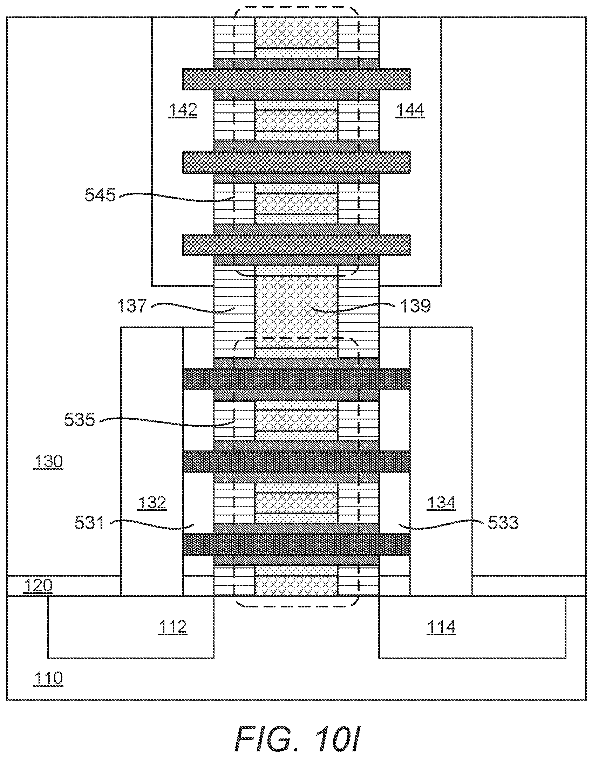

FIG. 10I illustrates a stage in which the upper GAA gate region 545 is formed. Here, the areas for the upper source and drain contacts 142, 144 may be pattemed in the IMD layer 130. The patterned areas may be deposited with conductive materials (e.g., Pd, Ni, Au, W, Ta, TaN, Ti, TiN, Bi, Sb, Mo, Ru, etc.) and polished (e.g., CMP).

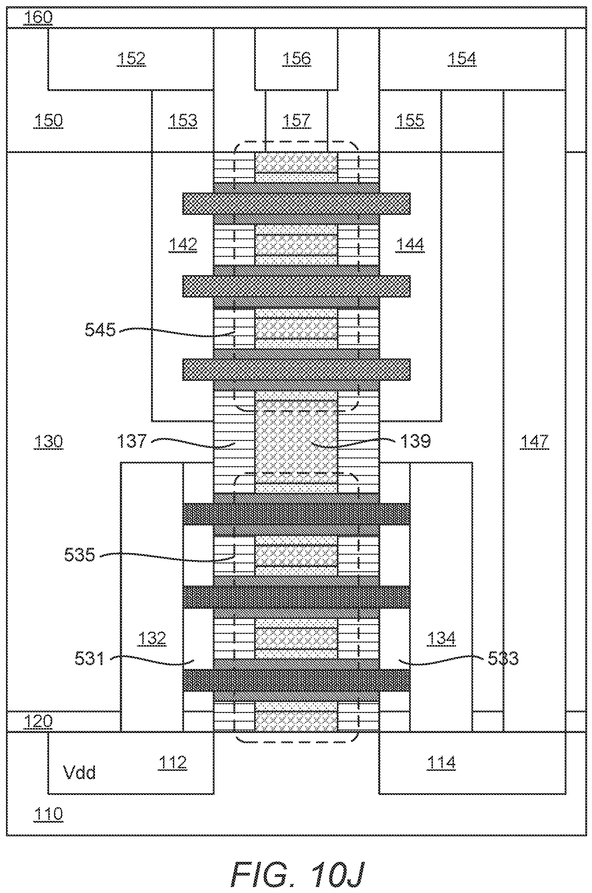

FIG. 10J illustrates a stage in which more IMD oxide layer may be deposited and patterned to form the upper IMD layer 150. Here, metal layer x+1 may be deposited and patterned to form the upper source terminal 152, upper drain terminal 154, and the upper gate terminal 156. The source, drain, and gate vias 153, 155, 157 may also be formed. Further, the lower protection layer 120, the IMD layer 130, and the upper IMD layer 150 may be patterned, and conductive material may be deposited in the patterned area to form the tail via 147. The upper protection layer 160 may be formed on the upper IMD layer 150 by depositing and patterning (e.g., polishing) protection material (e.g., SiCN).

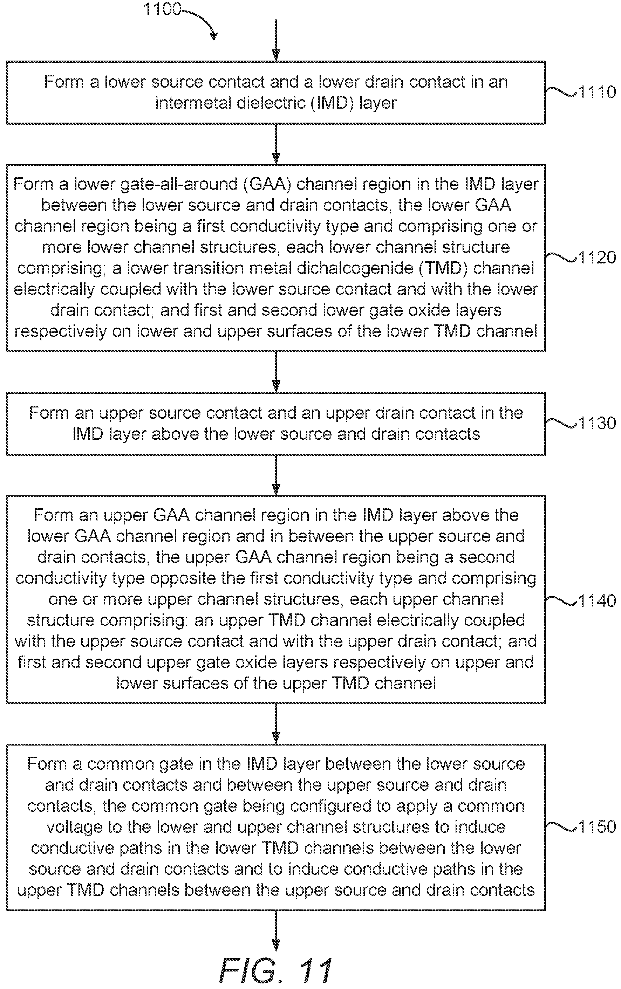

FIG. 11 illustrates a flow chart of an example method 1100 of manufacturing a CFET structure (e.g., CFET structures 100, 300, 400, 500, 700, 800) in accordance with at one or more aspects of the disclosure. In block 1110, a lower source contact (e.g., lower source contact 132) and a lower drain contact (e.g., lower drain contact 134) may be formed in an intermetal dielectric (IMD) layer (e.g., IMD layer 130). Block 1110 may correspond to the stages illustrated in FIGS. 9E and 10E.

In block 1120, a lower gate-all-around (GAA) gate region (e.g., a lower GAA gate region 135) may be formed in the IMD layer between the lower source and drain contacts (e.g., lower source and drain contact 132, 134). The lower GAA gate region may be a first conductivity type (e.g., P-type) and may comprise one or more lower channel structures (e.g., lower channel structures 210, 610). Each lower channel structure may comprise a lower transition metal dichalcogenide (TMD) channel (e.g., lower TMD channel 212, 612). The lower TMD channel may be electrically coupled with the lower source contact and with the lower drain contact. The lower TMD channel may also comprise first and second lower gate oxide layers (e.g., lower gate oxide layers 214, 614) respectively on lower and upper surfaces of the lower TMD channel. The lower channel structure may further comprise first and second lower work function layers (e.g., lower work function layers 216, 616) respectively on a lower surface of the first lower gate oxide layer and on an upper surface of the second lower gate oxide layer. Block 1120 may correspond to the stages illustrated in FIGS. 9B-9E and 10B-10E.

In block 1130, an upper source contact (e.g., upper source contact 142) and an upper drain contact (e.g., upper drain contact 144) may be formed in the IMD layer above the lower source and drain contacts. Block 1130 may correspond to the stages illustrated in FIGS. 9I and 10I.

In block 1140, an upper gate-all-around (GAA) gate region (e.g., an upper GAA gate region 145) may be formed in the IMD layer between the upper source and drain contacts. The upper GAA gate region may be a second conductivity type (e.g., N-type) opposite the first conductivity type and may comprise one or more upper channel structures (e.g., upper channel structures 250, 650). Each upper channel structure may comprise an upper transition metal dichalcogenide (TMD) channel (e.g., upper TMD channel 252, 652). The upper TMD channel may be electrically coupled with the upper source contact and with the upper drain contact. The upper TMD channel may also comprise first and second upper gate oxide layers (e.g., upper gate oxide layers 254, 654) respectively on lower and upper surfaces of the upper TMD channel. The upper channel structure may further comprise first and second upper work function layers (e.g., upper work function layers 256, 656) respectively on an upper surface of the first upper gate oxide layer and on an upper surface of the second upper gate oxide layer. Block 1140 may correspond to the stages illustrated in FIGS. 9F-9I and 10F-10I.

In block 1150, a common gate (e.g., common gate 139) may be formed in the IMD layer between the lower source and drain contacts and between the upper source and drain contacts. The common gate may be configured to apply a common voltage to the lower and upper channel structures to induce conductive paths in the lower TMD channels between the lower source and drain contacts and to induce conductive paths in the upper TMD channels between the upper source and drain contacts. Block 1150 may correspond to the stages illustrated in FIGS. 9D, 9H, 10D, and 10H.

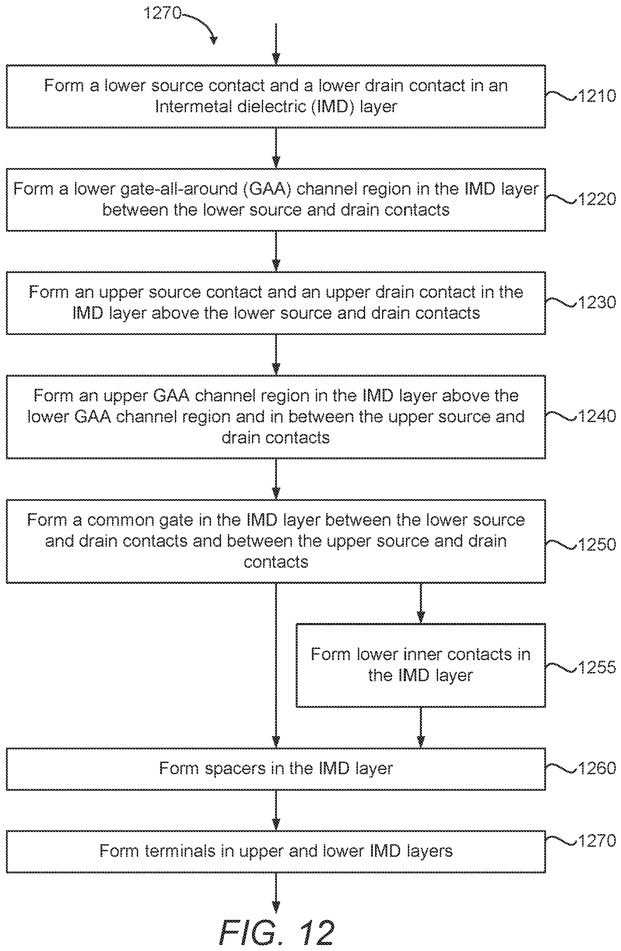

FIG. 12 illustrates a flow chart of an example method 1200 of manufacturing a CFET structure (e.g., CFET structures 100, 300, 400, 500, 700, 800) in accordance with at one or more aspects of the disclosure. FIG. 12 may be view as being more comprehensive than FIG. 11.

Thus, blocks 1210 - 1250 may be similar to blocks 1110 - 1150. Therefore, detailed descriptions of blocks 1210 - 1250 will be omitted for sake of brevity.

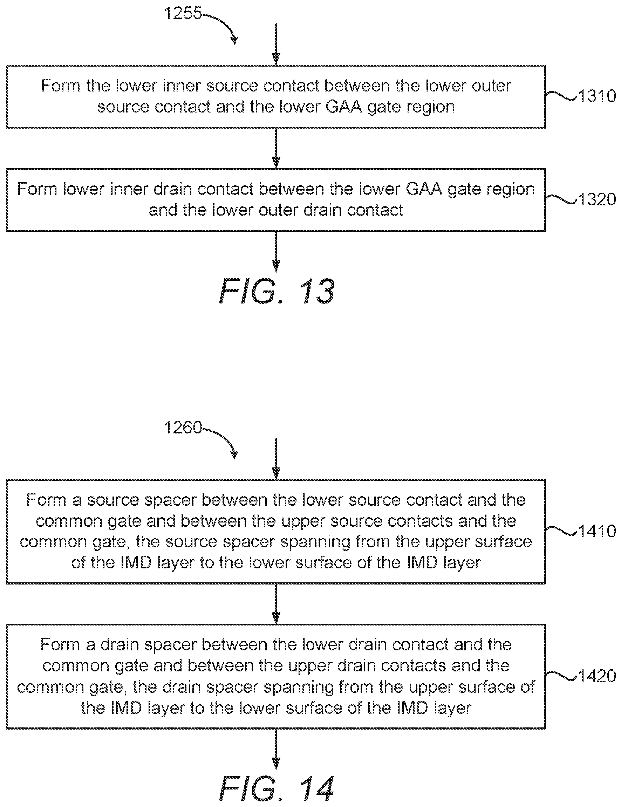

In block 1255, lower inner contacts may be formed in the IMD layer. FIG. 13 illustrates a flow chart of an example process to implement block 1255. In block 1310, a lower inner source contact (e.g., lower inner source 531) may be formed between the lower outer source contact and the lower GAA gate region. Block 1310 may correspond to the stage illustrated in FIG. 10H.

In block 1320, a lower inner drain contact (e.g., lower inner contact 533) may be formed between the lower GAA gate region and the lower outer drain contact. Block 1310 may also correspond to the stage illustrated in FIG. 10H.

Referring back to FIG. 12, in block 1260, spacers may be formed in the IMD layer. FIG. 14 illustrates a flow chart of an example process to implement block 1260. In block 1410, a source spacer (e.g., left spacer 137, 537) may be formed between the lower source contact and the common gate and between the upper source contact and the common gate. The source spacer may span from the upper surface of the IMD layer to the lower surface of the IMD layer. Block 1410 may correspond to the stages illustrated in FIGS. 9C, 9F, 10C, and 10F.

In block 1420, a drain spacer (e.g., right spacer 137, 537) may be formed between the lower drain contact and the common gate and between the upper drain contact and the common gate 139. The drain spacer may span from the upper surface of the IMD layer to the lower surface of the IMD layer. Block 1420 may also correspond to the stages illustrated in FIGS. 9C, 9F, 10C, and 10F.

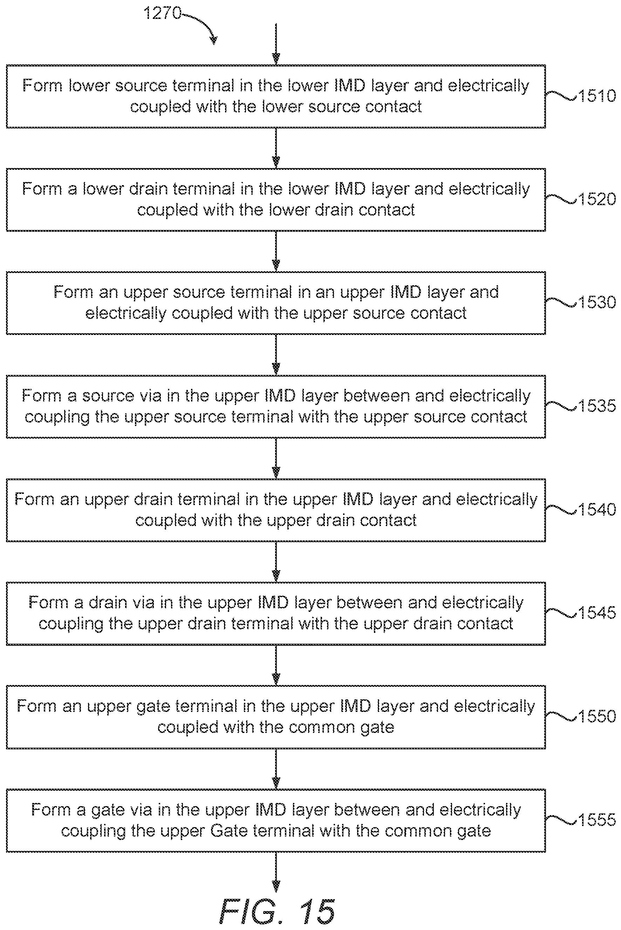

Referring back to FIG. 12, in block 1270, terminals may be formed in the upper and lower IMD layers (e.g., upper IMD layer 150, lower IMD layer 110). FIG. 15 illustrates a flow chart of an example process to implement block 1270. In block 1510, a lower source terminal (e.g., lower source terminal 112) may be formed in the lower IMD layer. The lower source terminal may be electrically coupled with the lower source contact. The lower IMD layer may be on a lower surface of the IMD layer. Block 1510 may correspond to the stages illustrated in FIGS. 9A and 10A.

In block 1520, a lower drain terminal (e.g., lower drain terminal 114) may be formed in the lower IMD layer. The lower drain terminal may be electrically coupled with the lower source contact. Block 1520 may correspond to the stages illustrated in FIGS. 9A and 10A.

In block 1530, an upper source terminal (e.g., upper source terminal 152) may be formed in the upper IMD layer. The upper source terminal may be electrically coupled with the upper source contact. The upper IMD layer may be on an upper surface of the IMD layer. Block 1530 may correspond to the stages illustrated in FIGS. 9J and 10J.

In block 1535, a source via (e.g., source via 153) may be formed in the upper IMD layer. The source via may electrically couple the upper source terminal with the upper source contact. Block 1535 may correspond to the stages illustrated in FIGS. 9J and 10J.

In block 1540, an upper drain terminal (e.g., upper drain terminal 154) may be formed in the upper IMD layer. The upper drain terminal may be electrically coupled with the upper drain contact. Block 1540 may correspond to the stages illustrated in FIGS. 9J and 10J.

In block 1545, a drain via (e.g., drain via 155) may be formed in the upper IMD layer. The drain via may electrically couple the upper drain terminal with the upper drain contact. Block 1545 may correspond to the stages illustrated in FIGS. 9J and 10J.

In block 1550, an upper gate terminal (e.g., upper gate terminal 156) may be formed in the upper IMD layer. The upper gate terminal may be electrically coupled with the common gate. Block 1550 may correspond to the stages illustrated in FIGS. 9J and 10J.

In block 1545, a gate via (e.g., gate via 157) may be formed in the upper IMD layer. The gate via may electrically couple the upper gate terminal with the common gate. Block 1555 may correspond to the stages illustrated in FIGS. 9J and 10J.

It will be appreciated that the foregoing fabrication processes and related discussion are provided merely as a general illustration of some of the aspects of the disclosure and is not intended to limit the disclosure or accompanying claims. Further, many details in the fabrication process known to those skilled in the art may have been omitted or combined in summary process portions to facilitate an understanding of the various aspects disclosed without a detailed rendition of each detail and/or all possible process variations. Further, it will be appreciated that the illustrated configurations and descriptions are provided merely to aid in the explanation of the various aspects disclosed herein. For example, the number and location of the inductors, the metallization structure may have more or less conductive and insulating layers, the cavity orientation, size, whether it is formed of multiple cavities, is closed or open, and other aspects may have variations driven by specific application design features, such as the number of antennas, antenna type, frequency range, power, etc. Accordingly, the forgoing illustrative examples and associated figures should not be construed to limit the various aspects disclosed and claimed herein.

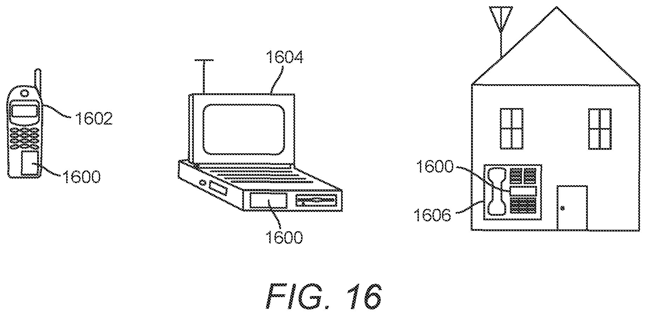

FIG. 16 illustrates various electronic devices 1600 that may be integrated with any of the aforementioned devices in accordance with various aspects of the disclosure. For example, a mobile phone device 1602, a laptop computer device 1604, and a fixed location terminal device 1606 may each be considered generally user equipment (UE) and may include one or more CFET structures (e.g., 100, 300, 400, 500, 700, 800) as described herein. The devices 1602, 1604, 1606 illustrated in FIG. 16 are merely exemplary. Other electronic devices may also include the RF filter including, but not limited to, a group of devices (e.g., electronic devices) that includes mobile devices, hand-held personal communication systems (PCS) units, portable data units such as personal digital assistants, global positioning system (GPS) enabled devices, navigation devices, set top boxes, music players, video players, entertainment units, fixed location data units such as meter reading equipment, communications devices, smartphones, tablet computers, computers, wearable devices, servers, routers, electronic devices implemented in automotive vehicles (e.g., autonomous vehicles), an Internet of things (IoT) device or any other device that stores or retrieves data or computer instructions or any combination thereof.

The foregoing disclosed devices and functionalities may be designed and configured into computer files (e.g., RTL, GDSII, GERBER, etc.) stored on computer-readable media. Some or all such files may be provided to fabrication handlers who fabricate devices based on such files. Resulting products may include semiconductor wafers that are then cut into semiconductor die and packaged into an antenna on glass device. The antenna on glass device may then be employed in devices described herein.

Implementation examples are described in the following numbered clauses:
Clause 1: A complementary field effect transistor (CFET) structure, comprising: a lower source contact and a lower drain contact in an intermetal dielectric (IMD) layer; a lower gate-all-around (GAA) gate region in the IMD layer between the lower source and drain contacts, the lower GAA gate region being a first conductivity type and comprising one or more lower channel structures, each lower channel structure comprising: a lower transition metal dichalcogenide (TMD) channel electrically coupled with the lower source contact and with the lower drain contact; and first and second lower gate oxide layers respectively on lower and upper surfaces of the lower TMD channel; an upper source contact and an upper drain contact in the IMD layer above the lower source and drain contacts; an upper GAA gate region in the IMD layer above the lower GAA gate region and between the upper source and drain contacts, the upper GAA gate region being a second conductivity type opposite the first conductivity type and comprising one or more upper channel structures, each upper channel structure comprising: an upper TMD channel electrically coupled with the upper source contact and with the upper drain contact; and first and second upper gate oxide layers respectively on upper and lower surfaces of the upper TMD channel; and a common gate in the IMD layer between the lower source and drain contacts and between the upper source and drain contacts, the common gate being configured to apply a common voltage to the lower and upper channel structures.
Clause 2: The CFET of clause 1, wherein each lower channel structure further comprises:
   a first lower work function layer on a lower surface of the first lower gate oxide layer;
   and a second lower work function layer on an upper surface of the second lower gate oxide layer, and wherein each upper channel structure further comprises: a first upper work function layer on a lower surface of the first upper gate oxide layer; and a second upper work function layer on an upper surface of the second upper gate oxide layer.
Clause 3: The CFET of clause 2, wherein the first lower work function layer or the second lower work function layer or both are formed from one or both of titanium nitride (TiN) or titanium alumina (TiAl), or wherein the first upper work function layer or the second upper work function layer or both are formed from one or both of TiN or TiAl, or both.
Clause 4: The CFET of any of clauses 1-3, wherein the lower TMD channel is formed from tungsten diselenide (WSe₂), and the upper TMD channel is formed from molybdenum disulfide (MoS₂).
Clause 5: The CFET of clause 4, wherein the lower TMD channel is formed from one or two layers of WSe₂, and wherein the upper TMD channel is formed from one or two layers of MoS₂.
Clause 6: The CFET of any of clauses 1-5, wherein the common gate spans from an upper surface of the IMD layer to a lower surface of the IMD layer.
Clause 7: The CFET of any of clauses 1-6, wherein the common gate is formed from tungsten (W), titanium nitride (TiN), or both.
Clause 8: The CFET of any of clauses 1-7, further comprising: a source spacer between the lower source contact and the common gate and between the upper source contact and the common gate, the source spacer spanning from an upper surface to a lower surface of the IMD layer; and a drain spacer between the lower drain contact and the common gate and between the upper drain contact and the common gate, the drain spacer spanning from the upper surface to the lower surface of the IMD layer.
Clause 9: The CFET of any of clauses 1-8, wherein the first lower gate oxide layer or the second lower gate oxide layer or both are high-k dielectric layers, or wherein the first upper gate oxide layer or the second upper gate oxide layer or both are high-k dielectric layers, or both.
Clause 10: The CFET of clause 9, wherein the first lower gate oxide layer or the second lower gate oxide layer or both are formed from a combination of hafnium oxide (HfO₂) and aluminum oxide (Al₂O₃) or a combination of Hf, HfO₂, and Al₂O₃, or wherein the first upper gate oxide layer or the second upper gate oxide layer or both are formed from a combination of HfO₂ and Al₂O₃) or a combination of Hf, HfO₂, and Al₂O₃, or both.
Clause 11: The CFET of any of clauses 1-10, further comprising: a lower inner source contact between the lower source contact and the lower GAA gate region; and a lower inner drain contact between the lower GAA gate region and the lower drain contact.
Clause 12: The CFET of clause 11, wherein the lower TMD channel extends into the lower inner source contact and/or into the lower inner drain contact, or wherein the upper TMD channel extends into the upper source contact and/or into the upper drain contact, or both.
Clause 13: The CFET of any of clauses 11-12, wherein the lower TMD channel is formed from one of tungsten diselenide (WSe₂) and molybdenum disulfide (MoS₂), and wherein the upper TMD channel is formed from other one of WSe₂ and MoS₂.
Clause 14: The CFET of any of clauses 1-13, further comprising: a lower source terminal in a lower IMD layer and electrically coupled with the lower source contact, the lower IMD layer being on a lower surface of the IMD layer; a lower drain terminal in the lower IMD layer and electrically coupled with the lower drain contact; an upper source terminal in an upper IMD layer and electrically coupled with the upper source contact, the upper IMD layer being on an upper surface of the IMD layer; an upper drain terminal in the upper IMD layer and electrically coupled with the upper drain contact; and an upper gate terminal in the upper IMD layer and electrically coupled with the common gate.
Clause 15: The CFET of clause 14, further comprising a source via in the upper IMD layer between and electrically coupling the upper source terminal with the upper source contact; a drain via in the upper IMD layer between and electrically coupling the upper drain terminal with the upper drain contact; and a gate via in the upper IMD layer between and electrically coupling the upper gate terminal with the common gate.
Clause 16: The CFET of any of clauses 14-15, further comprising a tail via in the IMD layer and in the upper IMD layer, the tail via electrically coupling the lower drain terminal with the upper drain terminal, wherein the CFET structure is configured to function as an inverter.
Clause 17: The CFET of any of clauses 14-15, further comprising: a second lower source contact and a second lower drain contact in the IMD layer; a second lower GAA gate region in the IMD layer between the second lower source and drain contacts, the second lower GAA gate region being the first conductivity type and comprising one or more second lower channel structures, each second lower channel structure comprising: a second lower TMD channel electrically coupled with the second lower source contact and with the second lower drain contact; and second-first and second-second lower gate oxide layers respectively on lower and upper surfaces of the second lower TMD channel; a second upper source contact and a second upper drain contact in the IMD layer above the second lower source and drain contacts; a second upper GAA gate region in the IMD layer above the second lower GAA gate region and between the second upper source and drain contacts, the second upper GAA gate region being the second conductivity type and comprising one or more second upper channel structures, each second upper channel structure comprising: a second upper TMD channel electrically coupled with the second upper source contact and with the second upper drain contact; and second-first and second-second upper gate oxide layers respectively on upper and lower surfaces of the second upper TMD channel; a second common gate in the IMD layer between the second lower source and drain contacts and between the second upper source and drain contacts, the second common gate being configured to apply a second common voltage to the second lower and upper channel structures; a second lower drain terminal in the lower IMD layer and electrically coupled with the second lower drain contact; a second upper drain terminal in the upper IMD layer and electrically coupled with the second upper drain contact; and a tail via in the IMD layer and in the upper IMD layer, the tail via electrically coupling the second lower drain terminal with the second upper drain terminal, wherein the upper drain terminal is also electrically coupled with the second upper source contact, and wherein the CFET structure is configured to function as a NAND logic.
Clause 18: The CFET of any of clauses 14-15, further comprising: a third lower source contact and a third lower drain contact in the IMD layer; a third lower GAA gate region in the IMD layer between the third lower source and drain contacts, the third lower GAA gate region being the first conductivity type and comprising one or more third lower channel structures, each third lower channel structure comprising: a third lower TMD channel electrically coupled with the third lower source contact and with the third lower drain contact; and third-first and third-second lower gate oxide layers respectively on lower and upper surfaces of the third lower TMD channel; a third upper source contact and a third upper drain contact in the IMD layer above the third lower source and drain contacts; a third upper GAA gate region in the IMD layer above the third lower GAA gate region and between the third upper source and drain contacts, the third upper GAA gate region being the second conductivity type and comprising one or more third upper channel structures, each third upper channel structure comprising: a third upper TMD channel electrically coupled with the third upper source contact and with the third upper drain contact; and third-first and third-second upper gate oxide layers respectively on upper and lower surfaces of the third upper TMD channel; a third common gate in the IMD layer between the third lower source and drain contacts and between the third upper source and drain contacts, the third common gate being configured to apply a third common voltage to the third lower and upper channel structures; a third lower drain terminal in the lower IMD layer and electrically coupled with the third lower drain contact; a third upper drain terminal in the upper IMD layer and electrically coupled with the third upper drain contact; and a tail via in the IMD layer and in the upper IMD layer, the tail via electrically coupling the third lower drain terminal with the third upper drain terminal, wherein the lower drain terminal is also electrically coupled with the third lower source contact, and wherein the CFET structure is configured to function as a NOR logic.
Clause 19: The CFET of any of clauses 14-18, further comprising: a lower protection layer between the lower IMD layer and the IMD layer; and an upper protection layer on the upper IMD layer.
Clause 20: The CFET of any of clauses 1-19, wherein the lower source contact is formed from palladium (Pd), nickel (Ni), gold (Au), tungsten (W), tantalum (Ta), tantalum nitride (TaN), titanium (Ti), titanium nitride (TiN), bismuth (Bi), antimony (Sb), molybdenum (Mo), ruthenium (Ru), or any combination thereof, and/or wherein the lower drain contact is formed from Pd, Ni, Au, W, Ta, TaN, Ti, TiN, Bi, Sb, Mo, Ru, or any combination thereof, and/or wherein the upper source contact is formed from Pd, Ni, Au, W, Ta, TaN, Ti, TiN, Bi, Sb, Mo, Ru, or any combination thereof, and/or wherein the upper drain contact is formed from Pd, Ni, Au, W, Ta, TaN, Ti, TiN, Bi, Sb, Mo, Ru, or any combination thereof.
Clause 21: The CFET of any of clauses 1-20, wherein the CFET structure is incorporated into an apparatus selected from the group consisting of a music player, a video player, an entertainment unit, a navigation device, a communications device, a mobile device, a mobile phone, a smartphone, a personal digital assistant, a fixed location terminal, a tablet computer, a computer, a wearable device, an Intemet of things (IoT) device, a laptop computer, a server, and a device in an automotive vehicle.
Clause 22: A method of fabricating a complementary field effect transistor (CFET) structure, the method comprising: forming a lower source contact and a lower drain contact in an intermetal dielectric (IMD) layer; forming a lower gate-all-around (GAA) gate region in the IMD layer between the lower source and drain contacts, the lower GAA gate region being a first conductivity type and comprising one or more lower channel structures, each lower channel structure comprising: a lower transition metal dichalcogenide (TMD) channel electrically coupled with the lower source contact and with the lower drain contact; and first and second lower gate oxide layers respectively on lower and upper surfaces of the lower TMD channel; forming an upper source contact and an upper drain contact in the IMD layer above the lower source and drain contacts; forming an upper GAA gate region in the IMD layer above the lower GAA gate region and between the upper source and drain contacts, the upper GAA gate region being a second conductivity type opposite the first conductivity type and comprising one or more upper channel structures, each upper channel structure comprising: an upper TMD channel electrically coupled with the upper source contact and with the upper drain contact; and first and second upper gate oxide layers respectively on upper and lower surfaces of the upper TMD channel; and forming a common gate in the IMD layer between the lower source and drain contacts and between the upper source and drain contacts, the common gate being configured to apply a common voltage to the lower and upper channel structures.
Clause 23: The method of clause 22, wherein each lower channel structure further comprises: a first lower work function layer on a lower surface of the first lower gate oxide layer; and a second lower work function layer on an upper surface of the second lower gate oxide layer, and wherein each upper channel structure further comprises: a first upper work function layer on a lower surface of the first upper gate oxide layer; and a second upper work function layer on an upper surface of the second upper gate oxide layer.
Clause 24: The method of any of clauses 22-23, wherein the lower TMD channel is formed from tungsten diselenide (WSe₂), and the upper TMD channel is formed from molybdenum disulfide (MoS₂).
Clause 25: The method of any of clauses 22-24, wherein the common gate is formed from tungsten (W), titanium nitride (TiN), or both.
Clause 26: The method of any of clauses 22-25, further comprising: forming spacers in the IMD layer, comprising: forming a source spacer between the lower source contact and the common gate and between the upper source contact and the common gate, the source spacer spanning from an upper surface of the IMD layer to a lower surface of the IMD layer; and forming a drain spacer between the lower drain contact and the common gate and between the upper drain contact and the common gate, the drain spacer spanning from the upper surface of the IMD layer to the lower surface of the IMD layer.
Clause 27: The method of any of clauses 22-26, further comprising: forming lower inner contacts in the IMD layer, comprising: forming a lower inner source contact between the lower source contact and the lower GAA gate region; and forming a lower inner drain contact between the lower GAA gate region and the lower drain contact.
Clause 28: The method of clause 27, wherein the lower TMD channel extends into the lower inner source contact and/or into the lower inner drain contact, or wherein the upper TMD channel extends into the upper source contact and/or into the upper drain contact, or both.
Clause 29: The method of any of clauses 22-28, further comprising: forming terminals in upper and lower IMD layers, comprising: forming a lower source terminal in the lower IMD layer and electrically coupled with the lower source contact, the lower IMD layer being on a lower surface of the IMD layer; forming a lower drain terminal in the lower IMD layer and electrically coupled with the lower drain contact; forming an upper source terminal in the upper IMD layer and electrically coupled with the upper source contact, the upper IMD layer being on an upper surface of the IMD layer; forming an upper drain terminal in the upper IMD layer and electrically coupled with the upper drain contact; and forming an upper gate terminal in the upper IMD layer and electrically coupled with the common gate.
Clause 30: The method of clause 29, wherein forming the terminals further comprises:
   forming a source via in the upper IMD layer between and electrically coupling the upper source terminal with the upper source contact; forming a drain via in the upper IMD layer between and electrically coupling the upper drain terminal with the upper drain contact;
   and forming a gate via in the upper IMD layer between and electrically coupling the upper gate terminal with the common gate.

As used herein, the terms "user equipment" (or "UE"), "user device," "user terminal," "client device," "communication device," "wireless device," "wireless communications device," "handheld device," "mobile device," "mobile terminal," "mobile station," "handset," "access terminal ," "subscriber device," "subscriber terminal," "subscriber station," "terminal," and variants thereof may interchangeably refer to any suitable mobile or stationary device that can receive wireless communication and/or navigation signals. These terms include, but are not limited to, a music player, a video player, an entertainment unit, a navigation device, a communications device, a smartphone, a personal digital assistant, a fixed location terminal, a tablet computer, a computer, a wearable device, a laptop computer, a server, an automotive device in an automotive vehicle, and/or other types of portable electronic devices typically carried by a person and/or having communication capabilities (e.g., wireless, cellular, infrared, short-range radio, etc.). These terms are also intended to include devices which communicate with another device that can receive wireless communication and/or navigation signals such as by short-range wireless, infrared, wireline connection, or other connection, regardless of whether satellite signal reception, assistance data reception, and/or position-related processing occurs at the device or at the other device. In addition, these terms are intended to include all devices, including wireless and wireline communication devices, that are able to communicate with a core network via a radio access network (RAN), and through the core network the UEs can be connected with external networks such as the Internet and with other UEs. Of course, other mechanisms of connecting to the core network and/or the Internet are also possible for the UEs, such as over a wired access network, a wireless local area network (WLAN) (e.g., based on IEEE 802.11, etc.) and so on. UEs can be embodied by any of a number of types of devices including but not limited to printed circuit (PC) cards, compact flash devices, external or internal modems, wireless or wireline phones, smartphones, tablets, tracking devices, asset tags, and so on. A communication link through which UEs can send signals to a RAN is called an uplink channel (e.g., a reverse traffic channel, a reverse control channel, an access channel, etc.). A communication link through which the RAN can send signals to UEs is called a downlink or forward link channel (e.g., a paging channel, a control channel, a broadcast channel, a forward traffic channel, etc.). As used herein the term traffic channel (TCH) can refer to either an uplink / reverse or downlink / forward traffic channel.

The wireless communication between electronic devices can be based on different technologies, such as code division multiple access (CDMA), W-CDMA, time division multiple access (TDMA), frequency division multiple access (FDMA), Orthogonal Frequency Division Multiplexing (OFDM), Global System for Mobile Communications (GSM), 3GPP Long Term Evolution (LTE), 5G New Radio, Bluetooth (BT), Bluetooth Low Energy (BLE), IEEE 802.11 (WiFi), and IEEE 802.15.4 (Zigbee/Thread) or other protocols that may be used in a wireless communications network or a data communications network. Bluetooth Low Energy (also known as Bluetooth LE, BLE, and Bluetooth Smart) is a wireless personal area network technology designed and marketed by the Bluetooth Special Interest Group intended to provide considerably reduced power consumption and cost while maintaining a similar communication range. BLE was merged into the main Bluetooth standard in 2010 with the adoption of the Bluetooth Core Specification Version 4.0 and updated in Bluetooth 5.

The word "exemplary" is used herein to mean "serving as an example, instance, or illustration." Any details described herein as "exemplary" is not to be construed as advantageous over other examples. Likewise, the term "examples" does not mean that all examples include the discussed feature, advantage or mode of operation. Furthermore, a particular feature and/or structure can be combined with one or more other features and/or structures. Moreover, at least a portion of the apparatus described herein can be configured to perform at least a portion of a method described herein.

It should be noted that the terms "connected," "coupled," or any variant thereof, mean any connection or coupling, either direct or indirect, between elements, and can encompass a presence of an intermediate element between two elements that are "connected" or "coupled" together via the intermediate element unless the connection is expressly disclosed as being directly connected.

Any reference herein to an element using a designation such as "first," "second," and so forth does not limit the quantity and/or order of those elements. Rather, these designations are used as a convenient method of distinguishing between two or more elements and/or instances of an element. Also, unless stated otherwise, a set of elements can comprise one or more elements.

Those skilled in the art will appreciate that information and signals may be represented using any of a variety of different technologies and techniques. For example, data, instructions, commands, information, signals, bits, symbols, and chips that may be referenced throughout the above description may be represented by voltages, currents, electromagnetic waves, magnetic fields or particles, optical fields or particles, or any combination thereof.

Nothing stated or illustrated depicted in this application is intended to dedicate any component, action, feature, benefit, advantage, or equivalent to the public, regardless of whether the component, action, feature, benefit, advantage, or the equivalent is recited in the claims.

In the detailed description above it can be seen that different features are grouped together in examples. This manner of disclosure should not be understood as an intention that the claimed examples have more features than are explicitly mentioned in the respective claim. Rather, the disclosure may include fewer than all features of an individual example disclosed. Therefore, the following claims should hereby be deemed to be incorporated in the description, wherein each claim by itself can stand as a separate example. Although each claim by itself can stand as a separate example, it should be noted that-although a dependent claim can refer in the claims to a specific combination with one or one or more claims-other examples can also encompass or include a combination of said dependent claim with the subject matter of any other dependent claim or a combination of any feature with other dependent and independent claims. Such combinations are proposed herein, unless it is explicitly expressed that a specific combination is not intended. Furthermore, it is also intended that features of a claim can be included in any other independent claim, even if said claim is not directly dependent on the independent claim.

It should furthermore be noted that methods, systems, and apparatus disclosed in the description or in the claims can be implemented by a device comprising means for performing the respective actions and/or functionalities of the methods disclosed.

Furthermore, in some examples, an individual action can be subdivided into one or more sub-actions or contain one or more sub-actions. Such sub-actions can be contained in the disclosure of the individual action and be part of the disclosure of the individual action.

While the foregoing disclosure shows illustrative examples of the disclosure, it should be noted that various changes and modifications could be made herein without departing from the scope of the disclosure as defined by the appended claims. The functions and/or actions of the method claims in accordance with the examples of the disclosure described herein need not be performed in any particular order. Additionally, well-known elements will not be described in detail or may be omitted so as to not obscure the relevant details of the aspects and examples disclosed herein. Furthermore, although elements of the disclosure may be described or claimed in the singular, the plural is contemplated unless limitation to the singular is explicitly stated.

## Claims

1. A complementary field effect transistor, CFET, structure, comprising:
a lower source contact (132) and a lower drain contact (134) in an intermetal dielectric, IMD, layer (130);
a lower gate-all-around, GAA, gate region (135) in the IMD layer (130) between the lower source and drain contacts (132, 134), the lower GAA gate region (135) being a first conductivity type and comprising one or more lower channel structures, each lower channel structure (210) comprising:
a lower transition metal dichalcogenide, TMD, channel (212) electrically coupled with the lower source contact (132) and with the lower drain contact (134); and
first and second lower gate oxide layers (214) respectively on lower and upper surfaces of the lower TMD channel (212);
an upper source contact (142) and an upper drain contact (144) in the IMD layer (130) above the lower source and drain contacts (132, 134);
an upper GAA gate region (145) in the IMD layer (130) above the lower GAA gate region (135) and between the upper source and drain contacts (142, 144), the upper GAA gate region (145) being a second conductivity type opposite the first conductivity type and comprising one or more upper channel structures, each upper channel structure (250) comprising:
an upper TMD channel (252) electrically coupled with the upper source contact and with the upper drain contact (142, 144); and
first and second upper gate oxide layers (254) respectively on lower and upper surfaces of the upper TMD channel (252); and
a common gate (139) in the IMD layer (130) between the lower source and drain contacts (132, 234) and between the upper source and drain contacts (142, 144), the common gate (139) being configured to apply a common voltage to the lower and upper channel structures (240, 250).

2. The CFET structure of claim 1,
wherein each lower channel structure further comprises:
a first lower work function layer on a lower surface of the first lower gate oxide layer; and
a second lower work function layer on an upper surface of the second lower gate oxide layer, and
wherein each upper channel structure further comprises:
a first upper work function layer on a lower surface of the first upper gate oxide layer; and
a second upper work function layer on an upper surface of the second upper gate oxide layer,
wherein the first lower work function layer or the second lower work function layer or both are formed from one or both of titanium nitride, TiN, or titanium alumina, TiAl, or
wherein the first upper work function layer or the second upper work function layer or both are formed from one or both of TiN or TiAI, or
both.

3. The CFET structure of claim 1, wherein the lower TMD channel is formed from tungsten diselenide (WSe₂), and the upper TMD channel is formed from molybdenum disulfide, MoS₂,
wherein the lower TMD channel is formed from one or two layers of WSe₂, and
wherein the upper TMD channel is formed from one or two layers of MoS₂.

4. The CFET structure of claim 1, wherein the common gate spans from an upper surface of the IMD layer to a lower surface of the IMD layer.

5. The CFET structure of claim 1, wherein the common gate is formed from tungsten, W, titanium nitride, TiN, or both.

6. The CFET structure of claim 1, further comprising:
a source spacer between the lower source contact and the common gate and between the upper source contact and the common gate, the source spacer spanning from an upper surface to a lower surface of the IMD layer; and
a drain spacer between the lower drain contact and the common gate and between the upper drain contact and the common gate, the drain spacer spanning from the upper surface to the lower surface of the IMD layer.

7. The CFET structure of claim 1,
wherein the first lower gate oxide layer or the second lower gate oxide layer or both are high-k dielectric layers, or
wherein the first upper gate oxide layer or the second upper gate oxide layer or both are high-k dielectric layers, or
both,
wherein the first lower gate oxide layer or the second lower gate oxide layer or both are formed from a combination of hafnium oxide, HfO₂, and aluminum oxide, Al₂O₃, or a combination of Hf, HfO₂, and Al₂O₃, or
wherein the first upper gate oxide layer or the second upper gate oxide layer or both are formed from a combination of HfO₂ and Al₂O₃ or a combination of Hf, HfO₂, and Al₂O₃, or
both.

8. The CFET structure of claim 1, further comprising:
a lower inner source contact between the lower source contact and the lower GAA gate region; and
a lower inner drain contact between the lower GAA gate region and the lower drain contact.

9. The CFET structure of claim 8,
wherein the lower TMD channel extends into the lower inner source contact and/or into the lower inner drain contact, or
wherein the upper TMD channel extends into the upper source contact and/or into the upper drain contact, or
both,
or,
wherein the lower TMD channel is formed from one of tungsten diselenide, WSe₂, and molybdenum disulfide, MoS₂, and
wherein the upper TMD channel is formed from other one of WSe₂ and MoS₂.

10. The CFET structure of claim 1, further comprising:
a lower source terminal in a lower IMD layer and electrically coupled with the lower source contact, the lower IMD layer being on a lower surface of the IMD layer;
a lower drain terminal in the lower IMD layer and electrically coupled with the lower drain contact;
an upper source terminal in an upper IMD layer and electrically coupled with the upper source contact, the upper IMD layer being on an upper surface of the IMD layer;
an upper drain terminal in the upper IMD layer and electrically coupled with the upper drain contact; and
an upper gate terminal in the upper IMD layer and electrically coupled with the common gate.

11. The CFET structure of claim 10, further comprising:
a source via in the upper IMD layer between and electrically coupling the upper source terminal with the upper source contact;
a drain via in the upper IMD layer between and electrically coupling the upper drain terminal with the upper drain contact; and
a gate via in the upper IMD layer between and electrically coupling the upper gate terminal with the common gate and/or, further comprising:
a tail via in the IMD layer and in the upper IMD layer, the tail via electrically coupling the lower drain terminal with the upper drain terminal,
wherein the CFET structure is configured to function as an inverter.

12. The CFET structure of claim 10, further comprising:
a second lower source contact and a second lower drain contact in the IMD layer;
a second lower GAA gate region in the IMD layer between the second lower source and drain contacts, the second lower GAA gate region being the first conductivity type and comprising one or more second lower channel structures, each second lower channel structure comprising:
a second lower TMD channel electrically coupled with the second lower source contact and with the second lower drain contact; and
second-first and second-second lower gate oxide layers respectively on lower and upper surfaces of the second lower TMD channel;
a second upper source contact and a second upper drain contact in the IMD layer above the second lower source and drain contacts;
a second upper GAA gate region in the IMD layer above the second lower GAA gate region and between the second upper source and drain contacts, the second upper GAA gate region being the second conductivity type and comprising one or more second upper channel structures, each second upper channel structure comprising:
a second upper TMD channel electrically coupled with the second upper source contact and with the second upper drain contact; and
second-first and second-second upper gate oxide layers respectively on upper and lower surfaces of the second upper TMD channel;
a second common gate in the IMD layer between the second lower source and drain contacts and between the second upper source and drain contacts, the second common gate being configured to apply a second common voltage to the second lower and upper channel structures;
a second lower drain terminal in the lower IMD layer and electrically coupled with the second lower drain contact;
a second upper drain terminal in the upper IMD layer and electrically coupled with the second upper drain contact; and
a tail via in the IMD layer and in the upper IMD layer, the tail via electrically coupling the second lower drain terminal with the second upper drain terminal,
wherein the upper drain terminal is also electrically coupled with the second upper source contact, and
wherein the CFET structure is configured to function as a NAND logic.

13. The CFET structure of claim 10, further comprising:
a third lower source contact and a third lower drain contact in the IMD layer;
a third lower GAA gate region in the IMD layer between the third lower source and drain contacts, the third lower GAA gate region being the first conductivity type and comprising one or more third lower channel structures, each third lower channel structure comprising:
a third lower TMD channel electrically coupled with the third lower source contact and with the third lower drain contact; and
third-first and third-second lower gate oxide layers respectively on lower and upper surfaces of the third lower TMD channel;
a third upper source contact and a third upper drain contact in the IMD layer above the third lower source and drain contacts;
a third upper GAA gate region in the IMD layer above the third lower GAA gate region and between the third upper source and drain contacts, the third upper GAA gate region being the second conductivity type and comprising one or more third upper channel structures, each third upper channel structure comprising:
a third upper TMD channel electrically coupled with the third upper source contact and with the third upper drain contact; and
third-first and third-second upper gate oxide layers respectively on upper and lower surfaces of the third upper TMD channel;
a third common gate in the IMD layer between the third lower source and drain contacts and between the third upper source and drain contacts, the third common gate being configured to apply a third common voltage to the third lower and upper channel structures;
a third lower drain terminal in the lower IMD layer and electrically coupled with the third lower drain contact;
a third upper drain terminal in the upper IMD layer and electrically coupled with the third upper drain contact; and
a tail via in the IMD layer and in the upper IMD layer, the tail via electrically coupling the third lower drain terminal with the third upper drain terminal,
wherein the lower drain terminal is also electrically coupled with the third lower source contact, and
wherein the CFET structure is configured to function as a NOR logic.

14. The CFET structure of claim 10, further comprising:
a lower protection layer between the lower IMD layer and the IMD layer; and
an upper protection layer on the upper IMD layer.

15. A method (1100) of fabricating a complementary field effect transistor, CFET, structure, the method comprising:
forming (1110) a lower source contact and a lower drain contact in an intermetal dielectric, IMD, layer;
forming (1120) a lower gate-all-around, GAA, gate region in the IMD layer between the lower source and drain contacts, the lower GAA gate region being a first conductivity type and comprising one or more lower channel structures, each lower channel structure comprising:
a lower transition metal dichalcogenide, TMD, channel electrically coupled with the lower source contact and with the lower drain contact; and
first and second lower gate oxide layers respectively on lower and upper surfaces of the lower TMD channel;
forming (1130) an upper source contact and an upper drain contact in the IMD layer above the lower source and drain contacts;
forming (1140) an upper GAA gate region in the IMD layer above the lower GAA gate region and between the upper source and drain contacts, the upper GAA gate region being a second conductivity type opposite the first conductivity type and comprising one or more upper channel structures, each upper channel structure comprising:
an upper TMD channel electrically coupled with the upper source contact and with the upper drain contact; and
first and second upper gate oxide layers respectively on upper and lower surfaces of the upper TMD channel; and
forming (1150) a common gate in the IMD layer between the lower source and drain contacts and between the upper source and drain contacts, the common gate being configured to apply a common voltage to the lower and upper channel structures.

## Patentansprüche

1. Eine Komplementärer-Feldeffekttransistor (Complementary Field Effect Transistor bzw. CFET)-Struktur, aufweisend:
einen unteren Source-Kontakt (132) und einen unteren Drain-Kontakt (134) in einer intermetallischen dielektrischen (Intermetal Dielectric bzw. IMD) Schicht (130),
einen unteren Gate-all-Around (GAA)-Gatebereich (135) in der IMD-Schicht (130) zwischen den unteren Source- und Drain-Kontakten (132, 134), wobei der untere GAA-Gatebereich (135) von einem ersten Leitfähigkeitstyp ist und eine oder mehrere untere Kanalstrukturen aufweist, wobei jede untere Kanalstruktur (210) aufweist:
einen unteren Übergangsmetall-Dichalkogenid (Transition Metal Dichalcogenide bzw. TMD)-Kanal (212), der elektrisch mit dem unteren Source-Kontakt (132) und mit dem unteren Drain-Kontakt (134) gekoppelt ist, und
erste und zweite untere Gateoxidschichten (214) jeweils an unteren und oberen Flächen des unteren TMD-Kanals (212),
einen oberen Source-Kontakt (142) und einen oberen Drain-Kontakt (144) in der IMD-Schicht (130) über den unteren Source- und Drain-Kontakten (132, 134),
einen oberen GAA-Gatebereich (145) in der IMD-Schicht (130) über dem unteren GAA-Gatebereich (135) und zwischen den oberen Source- und Drain-Kontakten (142, 144), wobei der obere GAA-Gatebereich (145) von einem zweiten Leitfähigkeitstyp, der dem ersten Leitfähigkeitstyp entgegengesetzt ist, ist und eine oder mehrere obere Kanalstrukturen aufweist, wobei jede obere Kanalstruktur (250) aufweist:
einen oberen TMD-Kanal (252), der elektrisch mit dem oberen Source-Kontakt und mit dem oberen Drain-Kontakt (142, 144) gekoppelt ist, und
erste und zweite obere Gateoxidschichten (254) jeweils an unteren und oberen Flächen des oberen TMD-Kanals (252), und
ein gemeinsames Gate (139) in der IMD-Schicht (130) zwischen den unteren Source- und Drain-Kontakten (132, 234) und zwischen den oberen Source- und Drain-Kontakten (142, 144), wobei das gemeinsame Gate (139) konfiguriert ist zum Anlegen einer gemeinsamen Spannung an den unteren und oberen Kanalstrukturen (240, 250).

2. CFET-Struktur nach Anspruch 1,
wobei jede untere Kanalstruktur weiterhin aufweist:
eine erste untere Arbeitsfunktionsschicht an einer unteren Fläche der ersten unteren Gateoxidschicht, und
eine zweite untere Arbeitsfunktionsschicht an einer oberen Fläche der zweiten unteren Gateoxidschicht,
und wobei jede obere Kanalstruktur weiterhin aufweist:
eine erste obere Arbeitsfunktionsschicht an einer unteren Fläche der ersten oberen Gateoxidschicht, und
eine zweite obere Arbeitsfunktionsschicht an einer oberen Fläche der zweiten oberen Gateoxidschicht,
wobei die erste untere Arbeitsfunktionsschicht und/oder die zweite untere Arbeitsfunktionsschicht aus Titannitrid (TiN) und/oder Titanaluminid (TiAl) ausgebildet sind, und/oder
wobei die erste obere Arbeitsfunktionsschicht und/oder die zweite obere Arbeitsfunktionsschicht aus TiN und/oder TiAl ausgebildet sind.

3. CFET-Struktur nach Anspruch 1, wobei der untere TMD-Kanal aus Wolframdiselenid (WSe₂) ausgebildet ist und der obere TMD-Kanal aus Molybdändisulfid (MoS₂) ausgebildet ist,
wobei der untere TMD-Kanal aus einer oder zwei Schichten von WSe₂ ausgebildet ist und
wobei der obere TMD-Kanal aus einer oder zwei Schichten von MOS₂ ausgebildet ist.

4. CFET-Struktur nach Anspruch 1, wobei sich das gemeinsame Gate von einer oberen Fläche der IMD-Schicht zu einer unteren Fläche der IMD-Schicht erstreckt.

5. CFET-Struktur nach Anspruch 1, wobei das gemeinsame Gate aus Wolfram (W) und/oder Titannitrid (TiN) ausgebildet ist.

6. CFET-Struktur nach Anspruch 1, die weiterhin aufweist:
ein Source-Abstandsglied zwischen dem unteren Source-Kontakt und dem gemeinsamen Gate und zwischen dem oberen Source-Kontakt und dem gemeinsamen Gate, wobei sich das Source-Abstandsglied von einer oberen Fläche zu einer unteren Fläche der IMD-Schicht erstreckt, und
ein Drain-Abstandsglied zwischen dem unteren Drain-Kontakt und dem gemeinsamen Gate und zwischen dem oberen Drain-Kontakt und dem gemeinsamen Gate, wobei sich das Drain-Abstandsglied von der oberen Fläche zu der unteren Fläche der IMD-Schicht erstreckt.

7. CFET-Struktur nach Anspruch 1,
wobei die erste untere Gateoxidschicht und/oder die zweite untere Gateoxidschicht high-k-dielektrische Schichten sind, und/oder
wobei die erste obere Gateoxidschicht und/oder die zweite obere Gateoxidschicht high-k-dielektrische Schichten sind,
wobei die erste untere Gateoxidschicht und/oder die zweite untere Gateoxidschicht aus einer Kombination von Hafniumoxid (HfO₂) und Aluminiumoxid (Al₂O₃) oder aus einer Kombination von Hf, HfO₂ und Al₂O3 ausgebildet sind, und/oder
wobei die erste obere Gateoxidschicht und/oder die zweite obere Gateoxidschicht aus einer Kombination von HfO₂ und Al₂O₃ oder aus einer Kombination von Hf, HfO₂ und Al₂O3 ausgebildet sind.

8. CFET-Struktur nach Anspruch 1, die weiterhin aufweist:
einen unteren inneren Source-Kontakt zwischen dem unteren Source-Kontakt und dem unteren GAA-Gatebereich, und
einen unteren inneren Drain-Kontakt zwischen dem unteren GAA-Gatebereich und dem unteren Drain-Kontakt.

9. CFET-Struktur nach Anspruch 8,
wobei sich der untere TMD-Kanal in den unteren inneren Source-Kontakt und/oder in den unteren inneren Drain-Kontakt erstreckt, und/oder
wobei sich der obere TMD-Kanal in den oberen Source-Kontakt und/oder in den oberen Drain-Kontakt erstreckt,
wobei der untere TMD-Kanal aus Wolframdiselenid (WSe₂) oder Molybdändisulfid (MoS₂) ausgebildet ist, und
wobei der obere TMD-Kanal aus dem anderen von WSe₂ und MoS₂ ausgebildet ist.

10. CFET-Struktur nach Anspruch 1, die weiterhin aufweist:
einen unteren Source-Anschluss, der in einer unteren IMD-Schicht angeordnet und elektrisch mit dem unteren Source-Kontakt gekoppelt ist, wobei die untere IMD-Schicht an einer unteren Fläche der IMD-Schicht vorgesehen ist,
einen unteren Drain-Anschluss, der in der unteren IMD-Schicht angeordnet und elektrisch mit dem unteren Drain-Kontakt gekoppelt ist,
einen oberen Source-Anschluss, der in einer oberen IMD-Schicht angeordnet und elektrisch mit dem oberen Source-Kontakt gekoppelt ist, wobei die obere IMD-Schicht an einer oberen Fläche der IMD-Schicht vorgesehen ist,
einen oberen Drain-Anschluss, der in der oberen IMD-Schicht angeordnet und elektrisch mit dem oberen Drain-Kontakt gekoppelt ist, und
einen oberen Gate-Anschluss, der in der oberen IMD-Schicht angeordnet ist und elektrisch mit dem gemeinsamen Gate gekoppelt ist.

11. CFET-Struktur nach Anspruch 10, die weiterhin aufweist:
eine Source-Durchkontaktierung, die in der oberen IMD-Schicht zwischen dem oberen Source-Anschluss und dem oberen Source-Kontaktangeordnet ist und diese elektrisch koppelt,
eine Drain-Durchkontaktierung, die in der oberen IMD-Schicht zwischen dem oberen Drain-Anschluss und dem oberen Drain-Kontakt angeordnet ist und diese elektrisch koppelt, und
eine Gate-Durchkontaktierung, die in der oberen IMD-Schicht zwischen dem oberen Gate-Anschluss und dem gemeinsamen Gate angeordnet ist und diese elektrisch koppelt,
und/oder weiterhin aufweist:
eine Tail-Durchkontaktierung, die in der IMD-Schicht und in der oberen IMD-Schicht angeordnet ist, wobei die Tail-Durchkontaktierung den unteren Drain-Anschluss elektrisch mit dem oberen Drain-Anschluss koppelt,
wobei die CFET-Struktur konfiguriert ist, um als ein Wechselrichter zu funktionieren.

12. CFET-Struktur nach Anspruch 10, die weiterhin aufweist:
einen zweiten unteren Source-Kontakt und einen zweiten unteren Drain-Kontakt in der IMD-Schicht,
einen zweiten unteren GAA-Gatebereich in der IMD-Schicht zwischen den zweiten unteren Source- und Drain-Kontakten, wobei der zweite untere GAA-Gatebereich vom ersten Leitfähigkeitstyp ist und eine oder mehrere zweite untere Kanalstrukturen aufweist, wobei jede zweite untere Kanalstruktur aufweist:
einen zweiten unteren TMD-Kanal, der elektrisch mit dem zweiten unteren Source-Kontakt und mit dem zweiten unteren Drain-Kontakt gekoppelt ist, und
zweite-erste und zweite-zweite untere Gateoxidschichten jeweils an unteren und oberen Flächen des zweiten unteren TMD-Kanals,
einen zweiten oberen Source-Kontakt und einen zweiten oberen Drain-Kontakt in der IMD-Schicht über den zweiten unteren Source- und Drain-Kontakten,
einen zweiten oberen GAA-Gatebereich in der IMD-Schicht über dem zweiten unteren GAA-Gatebereich und zwischen den zweiten oberen Source- und Drain-Kontakten, wobei der zweite obere GAA-Gatebereich vom zweiten Leitfähigkeitstyp ist und eine oder mehrere zweite obere Kanalstrukturen aufweist, wobei jede zweite obere Kanalstruktur aufweist:
einen zweiten oberen TMD-Kanal, der elektrisch mit dem zweiten oberen Source-Kontakt und mit dem zweiten oberen Drain-Kontakt gekoppelt ist, und
zweite-erste und zweite-zweite obere Gateoxidschichten jeweils an oberen und unteren Flächen des zweiten oberen TMD-Kanals,
ein zweites gemeinsames Gate in der IMD-Schicht zwischen den zweiten unteren Source- und Drain-Kontakten und zwischen den zweiten oberen Source- und Drain-Kontakten, wobei das zweite gemeinsame Gate konfiguriert ist zum Anlegen einer zweiten gemeinsamen Spannung an den zweiten unteren und oberen Kanalstrukturen,
einen zweiten unteren Drain-Anschluss, der in der unteren IMD-Schicht angeordnet ist und elektrisch mit dem zweiten unteren Drain-Kontakt gekoppelt ist,
einen zweiten oberen Drain-Anschluss, der in der oberen IMD-Schicht angeordnet ist und elektrisch mit dem zweiten oberen Drain-Kontakt gekoppelt ist, und
eine Tail-Durchkontaktierung in der IMD-Schicht und in der oberen IMD-Schicht, wobei die Tail-Durchkontaktierung den zweiten unteren Drain-Anschluss elektrisch mit dem zweiten oberen Drain-Anschluss kontaktiert,
wobei der obere Drain-Anschluss auch elektrisch mit dem zweiten oberen Source-Kontakt gekoppelt ist, und
wobei die CFET-Struktur konfiguriert ist, um als eine NAND-Logik zu funktionieren.

13. CFET-Struktur nach Anspruch 10, die weiterhin aufweist:
einen dritten unteren Source-Kontakt und einen dritten unteren Drain-Kontakt in der IMD-Schicht,
einen dritten unteren GAA-Gatebereich in der IMD-Schicht zwischen den dritten unteren Source- und Drain-Kontakten, wobei der dritte untere GAA-Gatebereich vom ersten Leitfähigkeitstyp ist und eine oder mehrere dritte untere Kanalstrukturen aufweist, wobei jede dritte untere Kanalstruktur aufweist:
einen dritten unteren TMD-Kanal, der elektrisch mit dem dritten unteren Source-Kontakt und mit dem dritten untern Drain-Kontakt gekoppelt ist, und
dritte-erste und dritte-zweite untere Gateoxidschichten jeweils an unteren und oberen Flächen des dritten unteren TMD-Kanals,
einen dritten oberen Source-Kontakt und einen dritten oberen Drain-Kontakt in der IMD-Schicht über den dritten unteren Source- und Drain-Kontakten,
einen dritten oberen GAA-Gatebereich in der IMD-Schicht über dem dritten unteren GAA-Gatebereich und zwischen den dritten oberen Source- und Drain-Kontakten, wobei der dritte obere GAA-Gatebereich vom zweiten Leitfähigkeitstyp ist und eine oder mehrere dritte obere Kanalstrukturen aufweist, wobei jede dritte obere Kanalstruktur aufweist:
einen dritten oberen TMD-Kanal, der elektrisch mit dem dritten oberen Source-Kontakt und mit dem dritten oberen Drain-Kontakt gekoppelt ist, und
dritte-erste und dritte-zweite obere Gateoxidschichten jeweils an oberen und unteren Flächen des dritten oberen TMD-Kanals,
ein drittes gemeinsames Gate in der IMD-Schicht zwischen den dritten unteren Source- und Drain-Kontakten und zwischen den dritten oberen Source- und Drain-Kontakten, wobei das dritte gemeinsame Gate konfiguriert ist zum Anlegen einer dritten gemeinsamen Spannung an den dritten unteren und oberen Kanalstrukturen,
einen dritten unteren Drain-Anschluss, der in der unteren IMD-Schicht angeordnet und elektrisch mit dem dritten unteren Drain-Kontakt gekoppelt ist,
einen dritten oberen Drain-Anschluss, der in der oberen IMD-Schicht angeordnet und elektrisch mit dem dritten oberen Drain-Kontakt gekoppelt ist, und
eine Tail-Durchkontaktierung in der IMD-Schicht und in der oberen IMD-Schicht, wobei die Tail-Durchkontaktierung den dritten unteren Drain-Anschluss elektrisch mit dem dritten oberen Drain-Anschluss koppelt,
wobei der untere Drain-Anschluss auch elektrisch mit dem dritten unteren Source-Kontakt gekoppelt ist, und
wobei die CFET-Struktur konfiguriert ist, um als eine NOR-Logik zu funktionieren.

14. CFET-Struktur nach Anspruch 10, die weiterhin aufweist:
eine untere Schutzschicht zwischen der unteren IMD-Schicht und der IMD-Schicht, und
eine obere Schutzschicht auf der oberen IMD-Schicht.

15. Ein Verfahren (1100) zum Herstellen einer Komplementärer-Feldeffekttransistor (Complementary Field Effect Transistor)-Struktur, wobei das Verfahren aufweist:
Ausbilden (1110) eines unteren Source-Kontakts und eines unteren Drain-Kontakts in einer intermetallischen dielektrischen (Intermetal Dielectric bzw. IMD)-Schicht,
Ausbilden (1120) eines unteren Gate-All-Around (GAA)-Gatebereichs in der IMD-Schicht zwischen den unteren Source- und Drain-Kontakten, wobei der untere GAA-Gatebereich von einem ersten Leitfähigkeitstyp ist und eine oder mehrere untere Kanalstrukturen aufweist, wobei jede untere Kanalstruktur aufweist:
einen unteren Übergangsmetall-Dichalkogenid (Transition Metal Dichalcogenide bzw. TMD)-Kanal, der elektrisch mit dem unteren Source-Kontakt und mit dem unteren Drain-Kontakt gekoppelt ist, und
erste und zweite untere Gateoxidschichten jeweils an unteren und oberen Flächen des unteren TMD-Kanals,
Ausbilden (1130) eines oberen Source-Kontakts und eines oberen Drain-Kontakts in der IMD-Schicht über den unteren Source- und Drain-Kontakten,
Ausbilden (1140) eines oberen GAA-Gatebereichs in der IMD-Schicht über dem unteren GAA-Gatebereich und zwischen den oberen Source- und Drain-Kontakten, wobei der obere GAA-Gatebereich von einem zweiten Leitfähigkeitstyp, der dem ersten Leitfähigkeitstyp entgegengesetzt ist, ist und eine oder mehrere obere Kanalstrukturen aufweist, wobei jede obere Kanalstruktur aufweist:
einen oberen TMD-Kanal, der elektrisch mit dem oberen Source-Kontakt und mit dem oberen Drain-Kontakt gekoppelt ist, und
erste und zweite obere Gateoxidschichten jeweils an oberen und unteren Flächen des oberen TMD-Kanals, und
Ausbilden (1150) eines gemeinsamen Gates in der IMD-Schicht zwischen den unteren Source- und Drain-Kontakten und zwischen den oberen Source- und Drain-Kontakten, wobei das gemeinsame Gate konfiguriert ist zum Anlegen einer gemeinsamen Spannung an den unteren und oberen Kanalstrukturen.

## Revendications

1. Structure de transistor à effet de champ complémentaire, CFET, comprenant :
un contact de source inférieur (132) et un contact de drain inférieur (134) dans une couche diélectrique intermétallique, IMD, (130) ;
une région de grille inférieure périphérique, GAA, (135) dans la couche IMD (130) entre les contacts de source et de drain inférieurs (132, 134), la région de grille GAA inférieure (135) étant d'un premier type de conductivité et comprenant une ou plusieurs structures de canal inférieures, chaque structure de canal inférieure (210) comprenant :
un canal en dichalcogénure de métal de transition, TMD, inférieur (212) relié électriquement au contact de source inférieur (132) et au contact de drain inférieur (134) ; et
des première et deuxième couches d'oxyde de grille inférieure (214) respectivement sur des surfaces inférieure et supérieure du canal TMD inférieur (212) ;
un contact de source supérieur (142) et un contact de drain supérieur (144) dans la couche IMD au-dessus des contacts de source et de drain inférieurs (132, 134) ;
une région de grille GAA supérieure (145) dans la couche IMD (130) au-dessus de la région de grille GAA inférieure (135) et entre les contacts de source et de drain supérieurs (142, 144), la région de grille GAA supérieure (145) étant d'un deuxième type de conductivité opposé au premier type de conductivité et comprenant une ou plusieurs structures de canal supérieures, chaque structure de canal supérieure (250) comprenant :
un canal TMD supérieur (252) relié électriquement au contact de source supérieur et au contact de drain supérieur (142, 144) ; et
des première et deuxième couches d'oxyde de grille supérieure (254) respectivement sur des surfaces inférieure et supérieure du canal TMD supérieur (252) ; et
une grille commune (139) dans la couche IMD (130) entre les contacts de source et de drain inférieurs (132, 134) et entre les contacts de source et de drain supérieurs (142, 144), la grille commune (139) étant configurée pour appliquer une tension commune aux structures de canal inférieure et supérieure (240, 250).

2. Structure CFET selon la revendication 1,
dans laquelle chaque structure de canal inférieure comprend en outre :
une première couche de fonction de travail inférieure sur une surface inférieure de la première couche d'oxyde de grille inférieure ; et
une deuxième couche de fonction de travail inférieure sur une surface supérieure de la deuxième couche d'oxyde de grille inférieure, et
dans laquelle chaque structure de canal supérieure comprend en outre :
une première couche de fonction de travail supérieure sur une surface inférieure de la première couche d'oxyde de grille supérieure ; et
une deuxième couche de fonction de travail supérieure sur une surface supérieure de la deuxième couche d'oxyde de grille supérieure,
dans laquelle la première couche de fonction de travail inférieure ou la deuxième couche de fonction de travail inférieure ou les deux sont constituées d'un ou des deux parmi le nitrure de titane, TiN, ou l'alumine de titane, TiAl, ou
dans laquelle la première couche de fonction de travail supérieure ou la deuxième couche de fonction de travail supérieure ou les deux sont constituées d'un ou des deux parmi le TiN ou le TiAl, ou
les deux.

3. Structure CFET selon la revendication 1, dans laquelle le canal TMD inférieur est constitué de diséléniure de tungstène (WSe₂), et le canal TMD supérieur est formé de disulfure de molybdène, MoS₂,
dans laquelle le canal TMD inférieur est constitué d'une ou deux couches de WSe₂, et
dans laquelle le canal TMD supérieur est constitué d'une ou deux couches de MoS₂.

4. Structure CFET selon la revendication 1, dans laquelle la grille commune s'étend d'une surface supérieure de la couche IMD à une surface inférieure de la couche IMD.

5. Structure CFET selon la revendication 1, dans laquelle la grille commune est constituée de tungstène, W, de nitrure de titane, TiN, ou des deux.

6. Structure CFET selon la revendication 1, comprenant en outre :
un espaceur de source entre le contact de source inférieur et la grille commune et entre le contact de source supérieur et la grille commune, l'espaceur de source s'étendant d'une surface supérieure à une surface inférieure de la couche IMD ; et
un espaceur de drain entre le contact de drain inférieur et la grille commune et entre le contact de drain supérieur et la grille commune, l'espaceur de drain s'étendant de la surface supérieure à la surface inférieure de la couche IMD.

7. Structure CFET selon la revendication 1,
dans laquelle la première couche d'oxyde de grille inférieure ou la deuxième couche d'oxyde de grille inférieure ou les deux sont des couches diélectriques à constante diélectrique élevée, ou
dans laquelle la première couche d'oxyde de grille supérieure ou la deuxième couche d'oxyde de grille supérieure ou les deux sont des couches diélectriques à constante diélectrique élevée, ou
les deux,
dans laquelle la première couche d'oxyde de grille inférieure ou la deuxième couche d'oxyde de grille inférieure ou les deux sont constituées d'une combinaison d'oxyde d'hafnium, HfO₂, et d'oxyde d'aluminium, Al₂O₃, ou d'une combinaison de Hf, HfO₂ et Al₂O₃, ou
dans laquelle la première couche d'oxyde de grille supérieure ou la deuxième couche d'oxyde de grille supérieure ou les deux sont constituées d'une combinaison de HfO₂ et Al₂O₃ ou d'une combinaison de Hf, HfO₂ et Al₂O₃, ou
les deux.

8. Structure CFET selon la revendication 1, comprenant en outre :
un contact de source interne inférieur entre le contact de source inférieur et la région de grille GAA inférieure ; et
un contact de drain interne inférieur entre la région de grille GAA inférieure et le contact de drain inférieur.

9. Structure CFET selon la revendication 8,
dans laquelle le canal TMD inférieur s'étend dans le contact de source interne inférieur et/ou dans le contact de drain interne inférieur, ou
dans laquelle le canal TMD supérieur s'étend dans le contact de source supérieur et/ou dans le contact de drain supérieur, ou
les deux,
ou,
dans laquelle le canal TMD inférieur est constitué de l'un parmi le diséléniure de tungstène, WSe₂, et le disulfure de molybdène, MoS₂, et
dans laquelle le canal TMD supérieur est constitué de l'autre parmi WSe₂ et MoS₂.

10. Structure CFET selon la revendication 1, comprenant en outre :
une borne de source inférieure dans une couche IMD inférieure et reliée électriquement au contact de source inférieur, la couche IMD inférieure étant sur une surface inférieure de la couche IMD ;
une borne de drain inférieure dans la couche IMD inférieure et reliée électriquement au contact de drain inférieur;
une borne de source supérieure dans une couche IMD supérieure et reliée électriquement au contact de source supérieur, la couche IMD supérieure étant sur une surface supérieure de la couche IMD ;
une borne de drain supérieure dans la couche IMD supérieure et reliée électriquement au contact de drain supérieur; et
une borne de grille supérieure dans la couche IMD supérieure et reliée électriquement à la grille commune.

11. Structure CFET selon la revendication 10, comprenant en outre :
un via de source dans la couche IMD supérieure entre et reliant électriquement la borne de source supérieure et le contact de source supérieur ;
un via de drain dans la couche IMD supérieure entre et reliant électriquement la borne de drain supérieure et le contact de drain supérieur ; et
un via de grille dans la couche IMD supérieure entre et reliant électriquement la borne de grille supérieure et la grille commune et/ou, comprenant en outre :
un via de queue dans la couche IMD et dans la couche IMD supérieure, le via de queue reliant électriquement la borne de drain inférieure et la borne de drain supérieure,
dans laquelle la structure CFET est configurée pour fonctionner comme un inverseur.

12. Structure CFET selon la revendication 10, comprenant en outre :
un deuxième contact de source inférieur et un deuxième contact de drain inférieur dans la couche IMD ;
une deuxième région de grille GAA inférieure dans la couche IMD entre les deuxièmes contacts de source et de drain inférieurs, la deuxième région de grille GAA inférieure étant du premier type de conductivité et comprenant une ou plusieurs deuxièmes structures de canal inférieur, chaque deuxième structure de canal inférieur comprenant :
un deuxième canal TMD inférieur relié électriquement au deuxième contact de source inférieur et au deuxième contact de drain inférieur ; et
des deuxième-première et deuxième-deuxième couches d'oxyde de grille inférieures respectivement sur les surfaces inférieure et supérieure du deuxième canal TMD inférieur ;
un deuxième contact de source supérieur et un deuxième contact de drain supérieur dans la couche IMD au-dessus des deuxièmes contacts de source et de drain inférieurs ;
une deuxième région de grille GAA supérieure dans la couche IMD au-dessus de la deuxième région de grille GAA inférieure et entre les deuxièmes contacts de source et de drain supérieurs, la deuxième région de grille GAA supérieure étant du deuxième type de conductivité et comprenant une ou plusieurs deuxièmes structures de canal supérieures, chaque deuxième structure de canal supérieure comprenant :
un deuxième canal TMD supérieur relié électriquement au deuxième contact de source supérieur et au deuxième contact de drain supérieur ; et
des deuxième-première et deuxième-deuxième couches d'oxyde de grille supérieure, respectivement sur les surfaces supérieure et inférieure du deuxième canal TMD supérieur ;
une deuxième grille commune dans la couche IMD, entre les deuxièmes contacts de source et de drain inférieurs et entre les deuxièmes contacts de source et de drain supérieurs, la deuxième grille commune étant configurée pour appliquer une deuxième tension commune aux deuxièmes structures de canal inférieure et supérieure ;
une deuxième borne de drain inférieure dans la couche IMD inférieure et reliée électriquement au deuxième contact de drain inférieur ;
une deuxième borne de drain supérieure dans la couche IMD supérieure et reliée électriquement au deuxième contact de drain supérieur ; et
un via de queue dans la couche IMD et dans la couche IMD supérieure, le via de queue reliant électriquement la deuxième borne de drain inférieure à la deuxième borne de drain supérieure,
dans laquelle la borne de drain supérieure est également reliée électriquement au deuxième contact de source supérieur, et
dans laquelle la structure CFET est configurée pour fonctionner comme une logique NON-ET.

13. Structure CFET selon la revendication 10, comprenant en outre :
un troisième contact de source inférieur et un troisième contact de drain inférieur dans la couche IMD ;
une troisième région de grille GAA inférieure dans la couche IMD entre les troisièmes contacts de source et de drain inférieurs, la troisième région de grille GAA inférieure étant du premier type de conductivité et comprenant une ou plusieurs troisièmes structures de canal inférieur, chaque troisième structure de canal inférieur comprenant :
un troisième canal TMD inférieur relié électriquement au troisième contact de source inférieur et au troisième contact de drain inférieur ; et
des troisième-première et troisième-deuxième couches d'oxyde de grille inférieures respectivement sur des surfaces inférieure et supérieure du troisième canal TMD inférieur ;
un troisième contact de source supérieur et un troisième contact de drain supérieur dans la couche IMD au-dessus des troisièmes contacts de source et de drain inférieurs ;
une troisième région de grille GAA supérieure dans la couche IMD au-dessus de la troisième région de grille GAA inférieure et entre les troisièmes contacts de source et de drain supérieurs, la troisième région de grille GAA supérieure étant du deuxième type de conductivité et comprenant une ou plusieurs troisièmes structures de canal supérieur, chaque troisième structure de canal supérieur comprenant :
un troisième canal TMD supérieur relié électriquement au troisième contact de source supérieur et au troisième contact de drain supérieur ; et
des troisième-première et troisième-deuxième couches d'oxyde de grille supérieure respectivement sur les surfaces supérieure et inférieure du troisième canal TMD supérieur ;
une troisième grille commune dans la couche IMD entre les troisièmes contacts de source et de drain inférieurs et entre les troisièmes contacts de source et de drain supérieurs, la troisième grille commune étant configurée pour appliquer une troisième tension commune aux troisièmes structures de canal inférieure et supérieure ;
une troisième borne de drain inférieure dans la couche IMD inférieure et reliée électriquement au troisième contact de drain inférieur ;
une troisième borne de drain supérieure dans la couche IMD supérieure et reliée électriquement au troisième contact de drain supérieur ; et
un via de queue dans la couche IMD et dans la couche IMD supérieure, le via de queue reliant électriquement la troisième borne de drain inférieure à la troisième borne de drain supérieure,
dans laquelle la borne de drain inférieure est également reliée électriquement au troisième contact de source inférieur, et
dans laquelle la structure CFET est configurée pour fonctionner comme une logique NON-OU.

14. Structure CFET selon la revendication 10, comprenant en outre :
une couche de protection inférieure entre la couche IMD inférieure et la couche IMD ; et
une couche de protection supérieure sur la couche IMD supérieure.

15. Procédé (1100) de fabrication d'une structure de transistor à effet de champ complémentaire, CFET, le procédé comprenant :
la formation (1110) d'un contact de source inférieur et d'un contact de drain inférieur dans une couche diélectrique intermétallique, IMD ;
la formation (1120) d'une région de grille périphérique, GAA, inférieure dans la couche IMD entre les contacts de source et de drain inférieurs, la région de grille GAA inférieure étant d'un premier type conductivité et comprenant une ou plusieurs structures de canal inférieures, chaque structure de canal inférieure comprenant :
un canal en dichalcogénure de métal de transition, TMD, inférieur relié électriquement au contact de source inférieur et au contact de drain inférieur ; et
des première et deuxième couches d'oxyde de grille inférieures respectivement sur les surfaces inférieure et supérieure du canal TMD inférieur ;
la formation (1130) d'un contact de source supérieur et un contact de drain supérieur dans la couche IMD au-dessus des contacts de source et de drain inférieurs ;
la formation (1140) d'une région de grille GAA supérieure dans la couche IMD au-dessus de la région de grille GAA inférieure et entre les contacts de source et de drain supérieurs, la région de grille GAA supérieure étant d'un deuxième type de conductivité opposé au premier type de conductivité et comprenant une ou plusieurs structures de canal supérieur, chaque structure de canal supérieur comprenant :
un canal TMD supérieur relié électriquement au contact de source supérieur et au contact de drain supérieur ; et
des première et deuxième couches d'oxyde de grille supérieures respectivement sur les surfaces supérieure et inférieure du canal TMD supérieur ; et
la formation (1150) d'une grille commune dans la couche IMD entre les contacts de source et de drain inférieurs et entre les contacts de source et de drain supérieurs, la grille commune étant configurée pour appliquer une tension commune aux structures de canal inférieur et supérieur.
